# EUROPEAN PATENT APPLICATION

(11) **EP 4 819 811 A1**
(43) Date of publication of application: **07.10.2026**
(21) Application number: 24898156.5
(22) Date of filing: 28.11.2024
(51) Int. Cl.: H10K 59/131, H10K 59/121, H10K 59/124, H10K 59/82, H10K 77/10, H10D 86/00, H10D 30/67, H10K 71/60

(54) **DISPLAY DEVICE AND ELECTRONIC DEVICE COMPRISING SAME**

(30) Priority: 29.11.2023 KR 20230169928; 22.10.2024 KR 20240145262
(71) Applicant: Samsung Display Co., Ltd., Yongin-si, Gyeonggi-do 17113 (KR)
(72) Inventor: CHAE, Soo Jung, Yongin-si, Gyeonggi-do 17113 (KR); KIM, Byeong Wan, Yongin-si, Gyeonggi-do 17113 (KR); PARK, Da Hye, Yongin-si, Gyeonggi-do 17113 (KR); SON, Mi Ji, Yongin-si, Gyeonggi-do 17113 (KR); SHIN, You Sik, Yongin-si, Gyeonggi-do 17113 (KR); HUR, Jin A, Yongin-si, Gyeonggi-do 17113 (KR)
(74) Representative: Marks & Clerk LLP
(86) International application number: PCT/KR2024/019126
(87) International publication number: WO 2025/116562

(57) **Abstract**

A display device includes a first conductive layer including first uppermost and lower layers, a first insulating layer covering the first conductive layer, a gate insulating layer on the first insulating layer, a second conductive layer on the gate insulating layer and including second uppermost and lower layers, a second insulating layer covering the second conductive layer, and a third conductive layer on the second insulating layer and connected to the first and second conductive layers through a first contact hole defined through the first and second insulating layers to expose a portion of the first uppermost layer and a second contact hole defined through the second insulating layer to expose a portion of the second uppermost layer. The third conductive layer is in contact with the portions of the first and second upper most layers exposed through the first and second contact holes.

## Description

### Technical Field

The disclosure relates to a display device and an electronic apparatus including the same.

### Background Art

A display device typically includes a plurality of pixels. Each of the plurality of pixels may emit light, and accordingly, the display device may display an image by combining light emitted from the plurality of pixels.

Each of the plurality of pixels may include various components such as transistors, interconnects, and electrodes. These various components may be implemented by electrically connecting a plurality of conductive layers disposed in different layers and at least one semiconductor layer. In this case, the above-described electrical connection may be made by forming contact holes in an insulating layer interposed between components disposed in different layers.

### Detailed Description of Invention

### Technical Problem

The disclosure is directed to providing a display device having improved display quality by improving the reliability of conductive layers included in a display device, and an electronic apparatus including the same.

### Technical Solution

A display device according to embodiments of the disclosure includes a substrate, a first conductive layer disposed on the substrate and including a first uppermost layer and a first lower layer below the first uppermost layer, a first insulating layer disposed on the substrate to cover the first conductive layer, a gate insulating layer disposed on the first insulating layer, a second conductive layer disposed on the gate insulating layer and including a second uppermost layer and a second lower layer below the second uppermost layer, a second insulating layer disposed on the first insulating layer to cover the second conductive layer, and a third conductive layer disposed on the second insulating layer and connected to each of the first conductive layer and the second conductive layer through a first contact hole and a second contact hole. In such embodiments, the first contact hole is defined through the first insulating layer and the second insulating layer to expose a first portion of the first uppermost layer, and the second contact hole is defined through the second insulating layer to expose a first portion of the second uppermost layer. In such embodiments, the third conductive layer is disposed in the first contact hole and the second contact hole and is in contact with the first portion of the first uppermost layer and the first portion of the second uppermost layer. In such embodiments, an upper surface of a second portion of the first uppermost layer is not in contact with the third conductive layer, and an upper surface of a second portion of the second uppermost layer is not in contact with the third conductive layer. In such embodiments, a thickness of the second portion of the second uppermost layer is greater than a thickness of the first portion of the second uppermost layer, and a thickness of the second portion of the first uppermost layer is greater than or equal to a thickness of the first portion of the first uppermost layer.

In an embodiment, the thickness of the second portion of the second uppermost layer may be greater than the thickness of the second portion of the first uppermost layer.

In an embodiment, the thickness of the second portion of the second uppermost layer may be in a range of about 300 angstroms to about 800 angstroms, and the thickness of the second portion of the first uppermost layer may be in a range of about 100 angstroms to about 700 angstroms.

In an embodiment, each of the first uppermost layer and the second uppermost layer may include titanium, and each of the first lower layer and the second lower layer may include aluminium.

In an embodiment, a difference between a depth of the first contact hole and a depth of the second contact hole may be in a range of about 2,000 angstroms to about 6,000 angstroms.

In an embodiment, a first depth may be defined as a difference between the thickness of the second portion of the first uppermost layer and the thickness of the first portion of the first uppermost layer, and a second depth may be defined as a difference between the thickness of the second portion of the second uppermost layer and the thickness of the first portion of the second uppermost layer. In such an embodiment, the second depth may be greater than the first depth.

In an embodiment, a difference between the second depth and the first depth may be proportional to a ratio of an etching rate of the second uppermost layer to an average etching rate of insulating layers between the first conductive layer and the second conductive layer in a dry etching.

In an embodiment, a difference between the second depth and the first depth may be proportional to a difference between a depth of the first contact hole and a depth of the second contact hole.

In an embodiment, the thickness of the first portion of the second uppermost layer may be greater than or equal to about 10 angstroms.

In an embodiment, a contact resistance of a contact surface between the third conductive layer and the second conductive layer may be about 1 ohm or less.

In an embodiment, the display device may further include a semiconductor layer disposed between the gate insulating layer and the first insulating layer. In such an embodiment, the third conductive layer may be connected to the semiconductor layer through a contact hole defined through the second insulating layer. In such an embodiment, the semiconductor layer may include polycrystalline silicon, monocrystalline silicon, low-temperature polycrystalline silicon, amorphous silicon, or an oxide semiconductor.

In an embodiment, the thickness of the second portion of the first uppermost layer may be in a range of about 3% to about 18% of a total thickness of the first conductive layer.

In an embodiment, the thickness of the second portion of the second uppermost layer may be in a range of about 13% to about 20% of a total thickness of the second conductive layer, and the thickness of the first portion of the second uppermost layer may be about 0.5% or greater of the total thickness of the second conductive layer.

A display device according to embodiments of the disclosure includes a substrate, a first conductive layer disposed on the substrate and including a first upper titanium layer and a first lower aluminium layer, a first insulating layer disposed on the substrate to cover the first conductive layer, a gate insulating layer disposed on the first insulating layer, a second conductive layer disposed on the gate insulating layer and including a second upper titanium layer and a second lower aluminium layer, a second insulating layer disposed on the first insulating layer to cover the second conductive layer, and a third conductive layer disposed on the second insulating layer and connected to each of the first conductive layer and the second conductive layer through a first contact hole and a second contact hole. In such embodiments, the first contact hole is defined through the first insulating layer and the second insulating layer to expose a first portion of the first upper titanium layer, and the second contact hole is defined through the second insulating layer to expose a first portion of the second upper titanium layer. In such embodiments, the third conductive layer is disposed in the first contact hole and the second contact hole and is in contact with the first portion of the first upper titanium layer and the first portion of the second upper titanium layer. In such embodiments, an upper surface of a second portion of the first upper titanium layer is not in contact with the third conductive layer, and an upper surface of a second portion of the second upper titanium layer is not in contact with the third conductive layer. In such embodiments, a thickness of the second portion of the second upper titanium layer is greater than a thickness of the first portion of the second upper titanium layer, and a thickness of the second portion of the first upper titanium layer is greater than or equal to a thickness of the first portion of the first upper titanium layer.

In an embodiment, the thickness of the second portion of the second upper titanium layer may be greater than the thickness of the second portion of the first uppermost layer.

In an embodiment, the thickness of the second portion of the second upper titanium layer may be in a range of about 300 angstroms to about 800 angstroms. In such an embodiment, the thickness of the second portion of the first upper titanium layer may be in a range of about 100 angstroms to about 700 angstroms.

In an embodiment, a difference between a depth of the first contact hole and a depth of the second contact hole may be in a range of about 2,000 angstroms to about 6,000 angstroms.

In an embodiment, a first depth may be defined as a difference between the thickness of the second portion of the first upper titanium layer and the thickness of a first portion of the first upper titanium layer, and a second depth may be defined as a difference between the thickness of the second portion of the second upper titanium layer and the thickness of the first portion of the second upper titanium layer. In such an embodiment, the second depth may be greater than the first depth.

In an embodiment, a difference between the second depth and the first depth may be proportional to a ratio of an etching rate of the second upper titanium layer to an average etching rate of insulating layers between the first conductive layer and the second conductive layer in a dry etching.

In an embodiment, a difference between the second depth and the first depth may be proportional to a difference between a depth of the first contact hole and a depth of the second contact hole.

In an embodiment, the thickness of the first portion of the second upper titanium layer may be greater than or equal to about 10 Angstroms.

In an embodiment, a contact resistance of a contact surface between the third conductive layer and the second conductive layer may be about 1 ohm or less.

In an embodiment, the display device may further include a semiconductor layer disposed between the gate insulating layer and the first insulating layer. In such an embodiment, the third conductive layer may be connected to the semiconductor layer through a contact hole defined through the second insulating layer. In such an embodiment, the semiconductor layer may include polycrystalline silicon, monocrystalline silicon, low-temperature polycrystalline silicon, amorphous silicon, or an oxide semiconductor.

In an embodiment, the thickness of the second portion of the first upper titanium layer may be in a range of about 3% to about 18% of a total thickness of the first conductive layer.

In an embodiment, the thickness of the second portion of the second upper titanium layer may be in a range of about 13% to about 20% of a total thickness of the second conductive layer, and the thickness of the first portion of the second upper titanium layer may be about 0.5% or greater of the total thickness of the second conductive layer.

An electronic apparatus according to embodiments of the disclosure includes a processor which provides input image data, a display device which displays an image based on the input image data, and a power supply which supplies power to the display device. In such embodiments, the display device includes a substrate, a first conductive layer disposed on the substrate and including a first uppermost layer and a first lower layer below the first uppermost layer, a first insulating layer disposed on the substrate to cover the first conductive layer, a gate insulating layer disposed on the first insulating layer, a second conductive layer disposed on the gate insulating layer and including a second uppermost layer and a second lower layer below the second uppermost layer, a second insulating layer disposed on the first insulating layer to cover the second conductive layer, and a third conductive layer disposed on the second insulating layer and connected to each of the first conductive layer and the second conductive layer through a first contact hole and a second contact hole. In such embodiments, the first contact hole is defined through the first insulating layer and the second insulating layer to expose a first portion of the first uppermost layer, and the second contact hole is defined through the second insulating layer to expose a first portion of the second uppermost layer. In such embodiments, the third conductive layer is disposed in the first contact hole and the second contact hole and may be in contact with the first portion of the first uppermost layer and the first portion of the second uppermost layer. In such embodiments, an upper surface of a second portion of the first uppermost layer is not in contact with the third conductive layer, and an upper surface of a second portion of the second uppermost layer is not in contact with the third conductive layer. In such embodiments, a thickness of the second portion of the second uppermost layer is greater than a thickness of the first portion of the second uppermost layer, and a thickness of the second portion of the first uppermost layer is greater than or equal to a thickness of the first portion of the first uppermost layer.

An electronic apparatus according to embodiments of the disclosure includes a processor which provides input image data, a display device which displays an image based on the input image data, and a power supply which supplies power to the display device. In such embodiments, the display device includes a substrate, a first conductive layer disposed on the substrate and including a first upper titanium layer and a first lower aluminium layer, a first insulating layer disposed on the substrate to cover the first conductive layer, a gate insulating layer disposed on the first insulating layer, a second conductive layer disposed on the gate insulating layer and including a second upper titanium layer and a second lower aluminium layer, a second insulating layer disposed on the first insulating layer to cover the second conductive layer, and a third conductive layer disposed on the second insulating layer and connected to each of the first conductive layer and the second conductive layer through a first contact hole and a second contact hole. In such embodiments, the first contact hole is defined through the first insulating layer and the second insulating layer to expose a first portion of the first upper titanium layer, and the second contact hole is defined through the second insulating layer to expose a first portion of the second upper titanium layer. In such embodiment, the third conductive layer is disposed in the first contact hole and the second contact hole and is in contact with the first portion of the first upper titanium layer and the first portion of the second upper titanium layer. In such embodiments, an upper surface of a second portion of the first upper titanium layer is not in contact with the third conductive layer, and an upper surface of a second portion of the second upper titanium layer is not in contact with the third conductive layer. In such embodiments, a thickness of the second portion of the second upper titanium layer is greater than a thickness of the first portion of the second upper titanium layer, and a thickness of the second portion of the first upper titanium layer is greater than or equal to a thickness of the first portion of the first upper titanium layer.

### Advantageous Effects

According to embodiments of the disclosure, it is possible to effectively prevent hillocks or voids from occurring in each of conductive layers disposed on different layers.

In addition, according to embodiments of the disclosure, where conductive layers disposed in different layers are connected (or electrically contacted) through contact holes, it is possible to effectively prevent an excessive increase in contact resistance in a contact surface between the conductive layers.

### Description of Drawings

FIG. 1 is a drawing for describing a display device according to an embodiment of the disclosure.
FIG. 2 is a circuit diagram for describing a pixel according to an embodiment of the disclosure.
FIG. 3 is a schematic view illustrating various components included in the pixel of FIG. 2.
FIG. 4 is a drawing for describing a structure in which components shown in FIG. 3 are electrically connected to each other through contact holes defined in an insulating layer array.
FIG. 5 is an enlarged view of region A of FIG. 4.
FIG. 6 is an enlarged view of region B of FIG. 4.
FIG. 7 is a cross-sectional view illustrating an embodiment in which a first transistor, a first capacitor, and a second capacitor of FIG. 2 are implemented by conductive layers shown in FIGS. 3 to 6.
FIG. 8 is a cross-sectional view illustrating an embodiment in which a second transistor and a third transistor of FIG. 2 are implemented by conductive layers shown in FIGS. 3 to 6.
FIG. 9 is an enlarged view of region X1 and the region X2 of FIG. 7.
FIG. 10 is an enlarged view of region Y1 of FIG. 7 and region Y2 of FIG. 8.
FIGS. 11 to 18 are views for describing a method of manufacturing a display device according to an embodiment of the disclosure.
FIG. 19 is a graph for describing a thickness of a second uppermost layer, which is required to prevent an excessive increase in contact resistance between a second conductive layer and a third conductive layer, according to a thickness of over-etched portions of insulating layers.
FIG. 20 is a drawing for describing an electronic apparatus including a display device of the disclosure.
FIG. 21 is a drawing illustrating an example in which the electronic apparatus of FIG. 20 is implemented as a smartphone.
FIG. 22 is a drawing illustrating an embodiment in which the electronic apparatus of FIG. 20 is implemented as a tablet personal computer (PC).

### Modes of the Invention

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present.

Throughout the specification, it will be understood that when an element is referred to as being "coupled" or "connected" to another element, it may be directly coupled or connected to the other element or intervening elements may be present therebetween.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. "At least any one of X, Y, and Z" or "at least one selected from X, Y, and Z" may be construed as each of X, Y, and Z or a combination of two or more of X, Y, and Z (for example, XYZ, XYY, YZ, and ZZ). It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations) and the spatially relative descriptors used herein interpreted accordingly.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

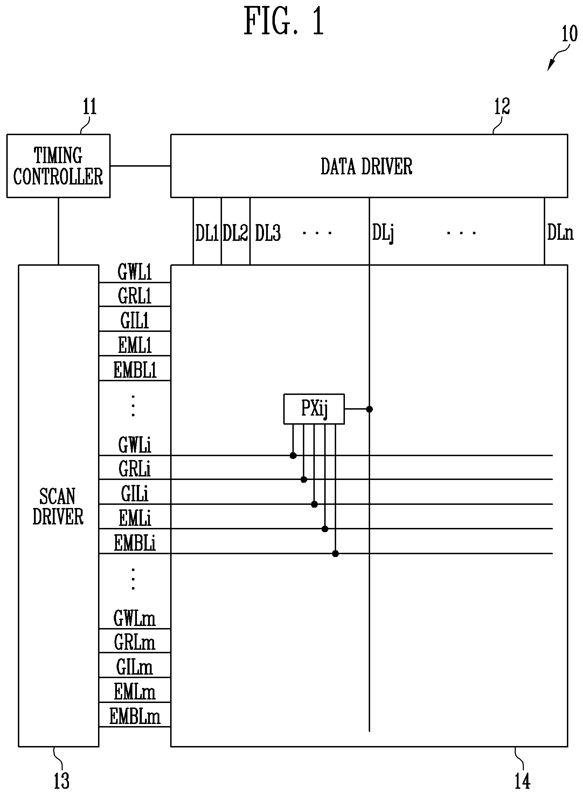

FIG. 1 is a view for describing a display device according to an embodiment of the disclosure.

Referring to FIG. 1, an embodiment of a display device 10 may include a timing controller 11, a data driver 12, a scan driver 13, and a pixel unit 14.

The timing controller 11 may receive an input image data including gradations for an image (or frame). The gradations may include a first color gradation, a second color gradation, and a third color gradation. The first color gradation may be a gradation for expressing a first color, the second color gradation may be a gradation for expressing a second color, and the third color gradation may be a gradation for expressing a third color.

In addition, the timing controller 11 may receive a control signal for an image. The control signal may include a horizontal synchronization signal, a vertical synchronization signal, and a data enable signal.

The vertical synchronization signal may include a plurality of pulses. Based on a time point at which each pulse occurs, a previous frame period may end, and a current frame period may start. In this case, an interval between adjacent pulses of the vertical synchronization signal may correspond to one frame period.

The horizontal synchronization signal may include a plurality of pulses. Based on a time point at which each pulse occurs, a previous horizontal period may end, and a new horizontal period may start. In this case, an interval between adjacent pulses of the horizontal synchronization signal may correspond to one horizontal period.

The data enable signal may have an enable level for certain horizontal periods and a disable level for the remaining periods. When the data enable signal is at an enable (or active) level, color gradations may be supplied in corresponding horizontal periods.

The timing controller 11 may provide rendered or corrected gradations to the data driver 12 according to the specifications of the display device 10. In addition, the timing controller 11 may provide a clock signal, a scan start signal, or the like to the scan driver 13.

The data driver 12 may generate data voltages to be provided to data lines DL1, DL2, DL3, ..., DLj, ..., and DLn using the gradations and control signals received from the timing controller 11. In an embodiment, for example, the data driver 12 may sample gradations using a clock signal and may apply data voltages corresponding to the gradations to data lines DL1 to DLn in pixel row units. Here, n may be an integer greater than 0, and a pixel row may refer to pixels connected to a same scan line.

The scan driver 13 may receive a clock signal, a scan start signal, or the like from the timing controller 11 and may generate scan signals to be provided to scan lines GWL1, GRL1, EML1, EMBL1, ..., GWLi, GRLi, GILi, EMLi, EMBLi, ..., GWLm, GRLm, GILm, EMLm, and EMBLm. Here, m may be an integer greater than 0. In an embodiment, for example, the scan driver 13 may include a first sub-scan driver connected to first scan lines GWL1, ..., GWLi, ..., and GWLm, a second sub-scan driver connected to second scan lines GRL1, ..., GRLi, ..., and GRLm, a third sub-scan driver connected to third scan lines GIL1, ..., GILi, ..., and GILm, a fourth sub-scan driver connected to fourth scan lines EML1, ..., EMLi, ..., and EMLm, and a fifth sub-scan driver connected to fifth scan lines EMBL1, ..., EMBLi, ..., and EMBLm.

In an embodiment, for example, the first sub-scan driver may sequentially provide scan signals having a pulse with a turn-on level to the first scan lines GWL1 to GWLm. In an embodiment, for example, the first sub-scan driver may be provided in the form of a shift register and may generate scan signals through a method of sequentially transmitting scan start signals in the form of a pulse with a turn-on level to a next stage circuit under the control of a clock signal. Since the second to fifth sub-scan drivers may also be implemented in substantially the same or similar manner as the first sub-scan driver described above, any repetitive detailed descriptions thereof are omitted.

The pixel unit 14 includes pixels. A pixel PXij may be connected to a corresponding data line, a scan line, and an emission line. Here, i and j can each independently be integers greater than 0. A pixel PXij may refer to a pixel connected to an i^{th} scan line and a j^{th} data line.

The pixel unit 14 may define a display region. That is, a region in which the pixel unit 14 is disposed in the display device 10 may be defined as a display region in which an image is displayed.

The pixel unit 14 may include first pixels that emit light with a first color, second pixels that emit light with a second color, and third pixels that emit light with a third color. The first color, the second color, and the third color may be different colors. In an embodiment, for example, the first color may be one color of red, green, and blue, the second color may be another color of red, green, and blue other than the first color, and the third color may be the remaining color of red, green, and blue other than the first and second colors. In addition, instead of red, green, and blue, magenta, cyan, and yellow may be used as the first to third colors.

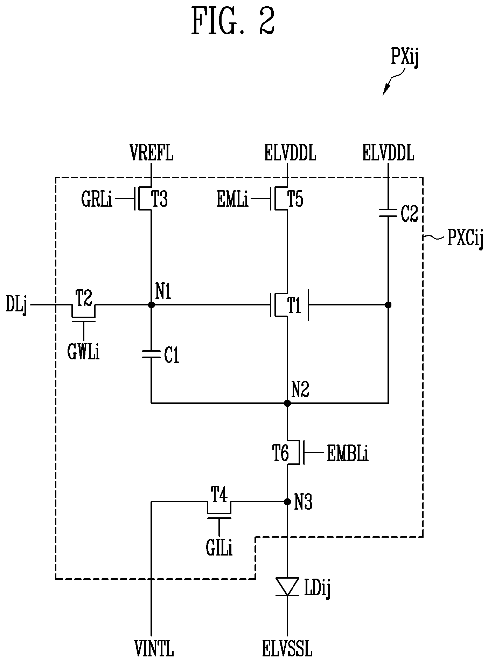

FIG. 2 is a circuit diagram for describing a pixel according to an embodiment of the disclosure.

Referring to FIG. 2, an embodiment of a pixel PXij may include a pixel circuit PXCij and a light-emitting element LDij electrically connected to the pixel circuit PXCij.

The pixel circuit PXCij may include at least one transistor and at least one capacitor. In an embodiment, for example, the pixel circuit PXCij may include transistors T1, T2, T3, T4, T5, and T6, a first capacitor C1, and a second capacitor C2. However, the number of transistors and the number capacitors included in the pixel circuit PXCij are not limited to those described above. The pixel circuit PXCij may include more or fewer transistors and/or capacitors according to operational characteristics thereof.

Hereinafter, an embodiment where all transistors in the pixel circuit PXCij are N-type transistors will be described. However, one skilled in the art will be able to design a circuit consisting of P-type transistors by varying the polarity of a voltage applied to a gate terminal. Similarly, one skilled in the art will be able to design a circuit consisting of a combination of P-type transistors and N-type transistors. Here, a P-type transistor is a general term for a transistor in which an amount of current increases when a voltage difference between a gate electrode and a source electrode increases in a negative direction, and an N-type transistor is a general term for a transistor in which an amount of current increases when a voltage difference between a gate electrode and a source electrode increases in a positive direction. Transistors may be provided in various forms such as thin film transistors (TFT), field effect transistors (FET), and bipolar junction transistors (BJT).

In an embodiment, the transistors T1, T2, T3, T4, T5, and T6 may be provided as N-type oxide thin film transistors. In another embodiment, the transistors T1, T2, T3, T4, T5, and T6 may be P-type silicon thin film transistors. In another embodiment, some of the transistors T1, T2, T3, T4, T5, and T6 may be N-type oxide thin film transistors, and others thereof may be P-type silicon thin film transistors.

The oxide thin film transistor may be a low temperature polycrystalline oxide (LTPO) thin film transistor in which a semiconductor layer includes an oxide. However, this is merely an example, and N-type transistors are not limited thereto. In an embodiment, for example, a semiconductor layer included in an N-type transistor may include an inorganic semiconductor (for example, amorphous silicon, monocrystalline silicon, or polysilicon) or an organic semiconductor. The silicon thin film transistor may be a low temperature poly-silicon (LTPS) thin film transistor in which a semiconductor layer includes amorphous silicon, monocrystalline silicon, poly silicon, or the like.

A first transistor T1 may include a first electrode connected to a second electrode of a fifth transistor T5 and a second electrode connected to a second node N2. The first transistor T1 may control an amount of driving current flowing from a first power line ELVDDL to a second power line ELVSSL. Therefore, the first transistor T1 may be referred to as a driving transistor.

In an embodiment, the first transistor T1 may have a double gate structure including a first gate electrode connected to a first node N1 and a second gate electrode connected to the second node N2. In such an embodiment, the first gate electrode of the first transistor T1 may be referred to as a top gate electrode, and the second gate electrode of the first transistor T1 may be referred to as a bottom gate electrode. The second gate electrode of the first transistor T1 may be used to adjust the characteristics of an output current versus an input voltage of the first transistor T1. In an embodiment, for example, the first transistor T1 mainly operates in a saturation state. In a case where the second gate electrode of the first transistor T1 is not present, a magnitude of an output current may vary according to a change in a drain-source voltage even though a gate-source voltage is the same. According to an embodiment, the characteristics of the first transistor T1 are adjusted to be insensitive to a change in a drain-source voltage, thereby allowing the first transistor T1 to output substantially a same current with respect to a same gate-source voltage.

A second transistor T2 may include a gate electrode connected to the first scan line GWLi, a first electrode connected to a data line DLj, and a second electrode connected to the first node N1. The second transistor T2 may receive a data voltage applied to the data line DLj. Therefore, the second transistor T2 may be referred to as a data write transistor.

A third transistor T3 may include a gate electrode connected to a second scan line GRLi, a first electrode connected to a reference voltage line VREFL to receive a reference voltage, and a second electrode connected to the first node N1. The third transistor T3 may initialize a voltage of the first node N1 to the reference voltage by applying a reference voltage to the first node N1. Therefore, the third transistor T3 may be referred to as a first initialization transistor.

A fourth transistor T4 may include a gate electrode connected to a third scan line GILi, a first electrode connected to an initialization voltage line VINTL to receive an initialization voltage, and a second electrode connected to a third node N3. The fourth transistor T4 may initialize a voltage of the third node N3 to the initialization voltage by applying the initialization voltage to the third node N3. Therefore, the fourth transistor T4 may be referred to as a second initialization transistor.

The fifth transistor T5 may include a gate electrode connected to a fourth scan line EMLi, a first electrode connected to the first power line ELVDDL, and a second electrode connected to the first electrode of the first transistor T1. The fifth transistor T5 may control the opening or closing of a driving current path connected from the first power line ELVDDL to the second power line ELVSSL. Therefore, the fifth transistor T5 may be referred to as a first emission control transistor.

A sixth transistor T6 may include a gate electrode connected to a fifth scan line EMBLi, a first electrode connected to the second node N2, and a second electrode connected to the third node N3. The sixth transistor T6 may control the opening or closing of the driving current path connected from the first power line ELVDDL to the second power line ELVSSL. Therefore, the sixth transistor T6 may be referred to as a second emission control transistor.

A first capacitor C1 may include a first terminal connected to the first node N1 and a second terminal connected to the second node N2. A second capacitor C2 may include a first terminal connected to the first power line ELVDDL and a second terminal connected to the second node N2.

A light-emitting element LDij may include an anode connected to the third node N3 and a cathode connected to the second power line ELVSSL. The light-emitting element LDij may be a light-emitting diode. The light-emitting element LDij may be include an organic light-emitting diode, an inorganic light-emitting diode, a quantum dot/well light-emitting diode, or the like. In an embodiment, each pixel is provided with only one light-emitting element LDij, but in other embodiments, each pixel may be provided with a plurality of light-emitting elements. In such embodiments, the plurality of light-emitting elements may be connected in series, parallel, or series-parallel manner. The light-emitting element LDij of each pixel may emit light with one of a first color, a second color, and a third color.

A first power voltage may be applied to the first power line ELVDDL, and a second power voltage may be applied to the second power line ELVSSL. In an embodiment, for example, the first power voltage may be greater than the second power voltage.

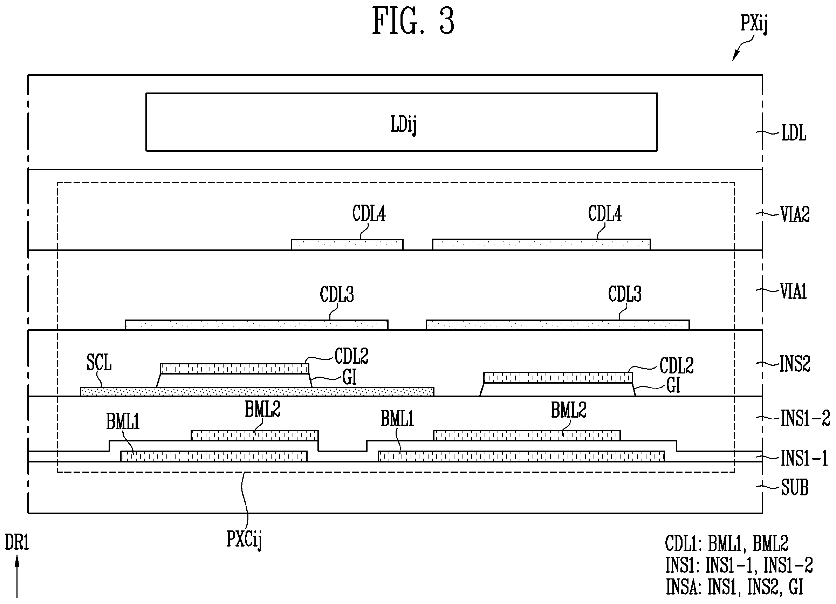

FIG. 3 is a schematic view illustrating various components included in the pixel of FIG. 2.

Referring to FIG. 3, a pixel PXij may include a substrate SUB, an insulating layer array INSA, a first conductive layer CDL1, a second conductive layer CDL2, a semiconductor layer SCL, a third conductive layer CDL3, a first via layer VIA1, a fourth conductive layer CDL4, a second via layer VIA2, and a light-emitting element layer LDL.

The substrate SUB may be rigid or flexible. In an embodiment, for example, the substrate SUB may include glass or plastic. The substrate SUB may serve as a base layer that provides a base for components disposed on the substrate SUB.

The insulating layer array INSA may include a plurality of insulating layers sequentially stacked in a first direction DR1. Here the first direction DR1 may be a thickness direction of the substrate SUB. In an embodiment, each of the plurality of insulating layers included in the insulating layer array INSA may be an inorganic insulating layer including at least one selected from various known inorganic insulating materials. In an embodiment, each of the plurality of insulating layers included in the insulating layer array INSA may have a single-layer or multi-layer structure.

The first via layer VIA1 and the second via layer VIA2 may be sequentially stacked on the insulating layer array INSA in the first direction DR1. In an embodiment, each of the first via layer VIA1 and the second via layer VIA2 may be an organic insulating layer including at least one selected from various known organic insulating materials and may have a single-layer or multi-layer structure. However, embodiments of the disclosure are not limited thereto. In an embodiment, each of the first via layer VIA1 and the second via layer VIA2 may have a double layer structure including an inorganic insulating layer and an organic insulating layer.

The fourth conductive layer CDL4 may be disposed between the first via layer VIA1 and the second via layer VIA2. The fourth conductive layer CDL4 may be disposed on the first via layer VIA1, and the second via layer VIA2 may cover the fourth conductive layer CDL4 on the first via layer VIA1.

The third conductive layer CDL3 may be disposed between the insulating layer array INSA and the first via layer VIA1. The third conductive layer CDL3 may be disposed on the insulating layer array INSA, and the first via layer VIA1 may cover the third conductive layer CDL3 on the insulating layer array INSA.

The first conductive layer CDL1, the semiconductor layer SCL, and the second conductive layer CDL2 may be disposed below the third conductive layer CDL3. Each of the first conductive layer CDL1, the semiconductor layer SCL, and the second conductive layer CDL2 may be disposed on (or below) one insulating layer of a plurality of insulating layers included in the insulating layer array INSA.

In an embodiment, the insulating layer array INSA may include a first insulating layer INS1, a gate insulating layer GI, and a second insulating layer INS2. In an embodiment, the first conductive layer CDL1 may be disposed on the substrate SUB, and the first insulating layer INS1 may cover the first conductive layer CDL1 on the substrate SUB. In an embodiment, the semiconductor layer SCL may be disposed on the first insulating layer INS1. In an embodiment, the gate insulating layer GI may be disposed on the semiconductor layer SCL and the first insulating layer INS1. In an embodiment, the second conductive layer CDL2 may be disposed on the gate insulating layer GI, and the second insulating layer INS2 may cover the semiconductor layer SCL, the gate insulating layer GI, and the second conductive layer CDL2 on the first insulating layer INS1.

In an embodiment, the first conductive layer CDL1 may include a first lower conductive layer BML1 and a second lower conductive layer BML2 disposed on a different layer from the first lower conductive layer BML1. In this case, in an embodiment, the first insulating layer INS1 may include a first first insulating layer (hereinafter, will be referred to as "1-1 insulating layer") INS1-1 and a first second insulating layer ((hereinafter, will be referred to as "1-2 insulating layer") INS1-2 disposed on the 1-1 insulating layer INS1-1. The first lower conductive layer BML1 may be disposed on the substrate SUB, and the 1-1 insulating layer INS1-1 may cover the first lower conductive layer BML1 on the substrate SUB. The second lower conductive layer BML2 may be disposed on the 1-1 insulating layer INS1-1, and the 1-2 insulating layer INS1-2 may cover the second lower conductive layer BML2 on the 1-1 insulating layer INS1-1. In this way, the first conductive layer CDL1 may include two or more conductive layers disposed on different layers below the second conductive layer CDL2.

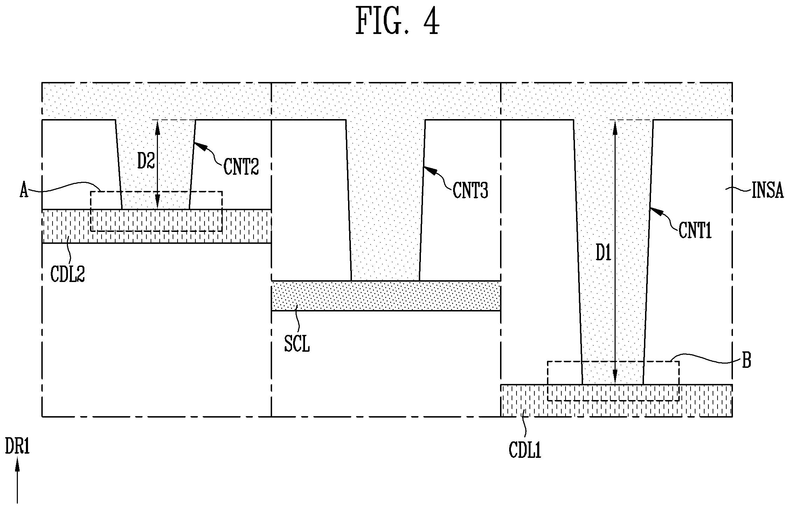

The first to fourth conductive layers CDL1, CDL2, CDL3, and CDL4 and the semiconductor layer SCL may form the pixel circuit PXCij. In an embodiment, for example, each of the first to fourth conductive layers CDL1, CDL2, CDL3, and CDL4 and the semiconductor layer SCL may include portions patterned in preset shapes as shown in FIG. 3. Transistors T1 to T6 (see FIG. 2), interconnects GWLi, GRLi, GILi, EMLi, EMBLi, ELVDDL, ELVSSL, and DLj (see FIG. 2), capacitors C1 and C2 (seen FIG. 2), electrodes (or interconnects) connecting the interconnects and the transistors and/or the capacitors may be implemented (or defined) by these patterned portions of the first to fourth conductive layers CDL1, CDL2, CDL3, and CDL4. In this case, according to an electrical connection relationship between components in the circuit diagram shown in FIG. 2, the conductive layers CDL1, CDL2, CDL3, and CDL4 and the semiconductor layer SCL may be electrically connected to each other through contact holes defined in the insulating layers INSA, VIA1, and VIA2. Electrical connections through these contact holes will be described below with reference to FIG. 4.

The light-emitting element layer LDL may be disposed on the second via layer VIA2. The light-emitting element layer LDL may include a light-emitting element LDij. The light-emitting element LDij may be electrically connected to the pixel circuit PXCij. In an embodiment, for example, the light-emitting element LDij may be electrically connected to the pixel circuit PXCij by being electrically connected to the fourth conductive layer CDL4 through a contact hole defined (or formed) in the second via layer VIA2.

An embodiment in which the pixel circuit PXCij is implemented by four conductive layers CDL1, CDL2, CDL3, and CDL4 and one semiconductor layer SCL is shown in FIG. 3 as an example. However, the number of conductive layers and the number of semiconductor layers for implementing the pixel circuit PXCij are not limited to that described above. In addition, an embodiment in which the semiconductor layer SCL is disposed between the first conductive layer CDL1 and the second conductive layer CDL2 is shown in FIG. 3 as an example. However, the arrangement of the semiconductor layer SCL is not limited to that described above.

A person skilled in the art will be able to design the pixel circuit PXCij by appropriately modifying the numbers of conductive layers and semiconductor layers and the arrangement of the conductive layers and semiconductor layers according to the operating characteristics of the pixel circuit PXCij. For example, a person skilled in the art will be able to design the pixel circuit PXCij by additionally disposing at least one conductive layer and/or at least one semiconductor layer between the first conductive layer CDL1 and the semiconductor layer SCL.

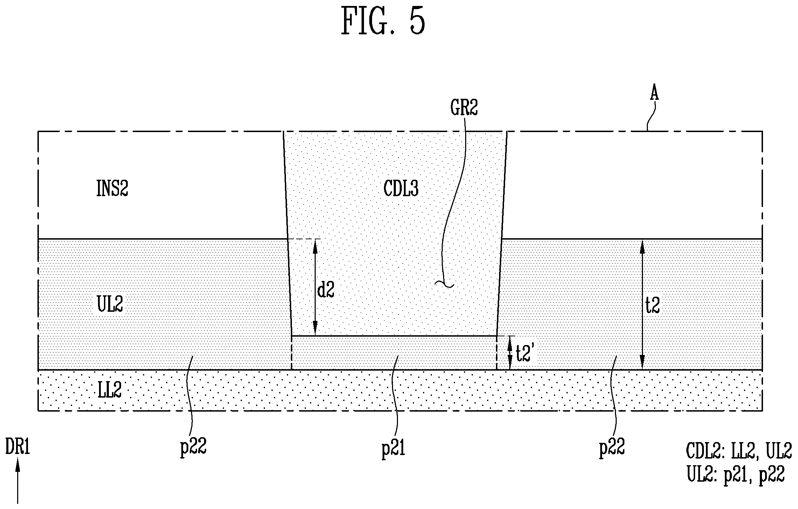

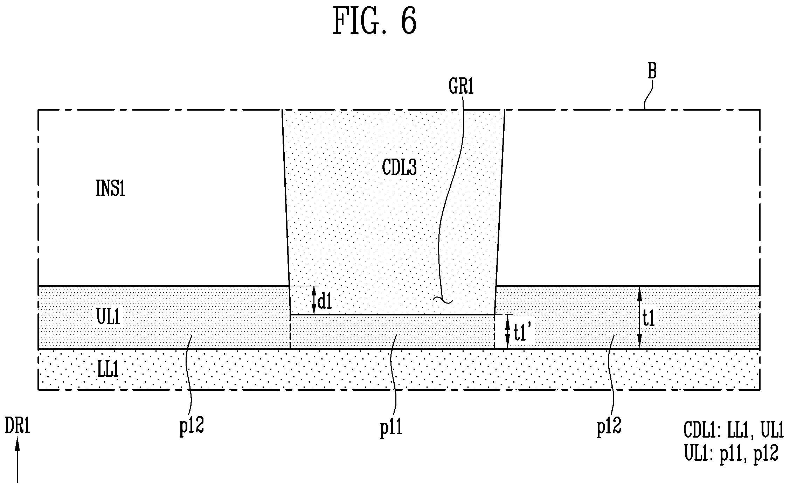

FIG. 4 is a drawing for describing a structure in which components shown in FIG. 3 are electrically connected to each other through contact holes defined in an insulating layer array. FIG. 5 is an enlarged view of region A of FIG. 4. FIG. 6 is an enlarged view of region B of FIG. 4.

Referring to FIGS. 3 to 6, in an embodiment of the disclosure, conductive layers CDL1 and CDL2 may have a multilayer structure, and upper surfaces of the conductive layers CDL1 and CDL2 are at least partially covered by insulating layers included in an insulating layer array INSA.

In an embodiment, as shown in FIG. 6, a first conductive layer CDL1 may include a first uppermost layer UL1 and a first lower layer LL1 disposed below the first uppermost layer UL1 and covered by the first uppermost layer UL1. In an embodiment, for example, the first conductive layer CDL1 may have a double-layer structure of titanium (Ti)/aluminium (Al). In such an embodiment, the first uppermost layer UL1 may be referred to as a first upper titanium layer, and the first lower layer LL1 may be referred to as a first lower aluminium layer. In another embodiment, for example, the first conductive layer CDL1 may have a triple-layer structure of titanium (Ti)/aluminium (Al)/titanium (Ti). In such an embodiment, the first uppermost layer UL1 may be referred to as a first upper titanium layer, the first lower layer LL1 may be referred to as a first lower aluminium layer, and a lower titanium layer not shown may be disposed below the first lower layer LL1. However, embodiments are not limited thereto. For example, embodiments of the disclosure may be applied to various cases in which the first conductive layer CDL1 includes a lower aluminium layer (for example, the first lower layer LL1) covered by an uppermost layer (for example, the first uppermost layer UL1), and the uppermost layer is disposed on the lower aluminium layer to serve as a capping layer for preventing hillocks or voids from occurring in the lower aluminium layer.

In an embodiment, where the first conductive layer CDL1 has the triple-layer structure of titanium (Ti)/aluminium (Al)/titanium (Ti) as described above, a thickness t1 of the first uppermost layer UL1, which is the first upper titanium layer, may be in a range of about 100 angstroms to about 700 angstroms, a thickness of the first lower layer LL1, which is the first lower aluminium layer, may be in a range of about 2000 angstroms to about 4000 angstroms, and a thickness of the lower titanium layer disposed below the first lower layer LL1 may be in a range of about 100 angstroms to about 200 angstroms.

In such an embodiment, the thickness t1 of the first uppermost layer UL1 of the first lower conductive layer BML1 may be in a range of about 100 angstroms to about 700 angstroms or in a range of about 300 angstroms to about 500 angstroms, and the thickness of the first lower layer LL1 of the first lower conductive layer BML1 may be in a range of about 2,000 angstroms to about 3,000 angstroms or in a range of about 2,400 angstroms to about 2,600 angstroms. In addition, in an embodiment, the thickness t1 of the first uppermost layer UL1 of the second lower conductive layer BML2 may be in a range of about 100 angstroms to about 700 angstroms or in a range of about 300 angstroms to about 500 angstroms, and the thickness of the first lower layer LL1 of the second lower conductive layer BML2 may be in a range of about 3,000 angstroms to about 4,000 angstroms or in a range of about 3,400 angstroms to about 3,600 angstroms.

In an embodiment, where the first lower conductive layer BML1 has the triple layer structure of titanium (Ti)/aluminium (Al)/titanium (Ti), the thickness t1 of the first uppermost layer UL1 of the first lower conductive layer BML1 may be in a range of about 200 angstroms to about 400 angstroms or in a range of about 250 angstroms to about 350 angstroms, or may be about 300 angstroms.

In embodiments, the thickness t1 of the first uppermost layer UL1 of the first lower conductive layer BML1 may be in a range of about 5% to about 14% of the total thickness of the first lower conductive layer BML1. When the thickness t1 of the first uppermost layer UL1 of the first lower conductive layer BML1 satisfies the numerical range described above, since the first uppermost layer UL1 is not formed to be excessively thin, the film quality of the first uppermost layer UL1 may be improved, and since the first uppermost layer UL1 is not formed to be excessively thick, the risk of undercut occurrence may be reduced, and mass productivity may be improved.

In addition, in the above-described embodiments, the thickness of the first lower layer LL1 of the first lower conductive layer BML1 may be in a range of about 81% or more to about 91% of the total thickness of the first lower conductive layer BML1. When the thickness of the first lower layer LL1 of the first lower conductive layer BML1 satisfies the above-described numerical range, since the overall thickness of the first lower conductive layer BML1 is not excessively thick, the problem that components positioned on the first lower conductive layer BML1 are disconnected due to a step difference caused by the first lower conductive layer BML1 may not occur.

In addition, in the above-described embodiments, the thickness of the lower titanium layer of the first lower conductive layer BML1 may be in a range of about 4.5% to about 5.4% of the total thickness of the first lower conductive layer BML1. When the thickness of the lower titanium layer of the first lower conductive layer BML1 satisfies the numerical range described above, the film quality of the lower titanium layer may be improved, the risk of undercut occurrence may be reduced, and mass productivity may be improved.

In an embodiment, where the first lower conductive layer BML1 has the triple-layer structure of titanium (Ti)/aluminium (Al)/titanium (Ti), the thickness t1 of the first uppermost layer UL1 of the first lower conductive layer BML1 may be in a range of about 400 angstroms to about 600 angstroms or in a range of about 450 angstroms to about 550 angstroms, or may be about 500 angstroms.

In the above-described embodiments, the thickness t1 of the first uppermost layer UL1 of the first lower conductive layer BML1 may be in a range of about 13% to about 18% of the total thickness of the first lower conductive layer BML1. When the thickness t1 of the first uppermost layer UL1 of the first lower conductive layer BML1 satisfies the numerical range described above, since the first uppermost layer UL1 is not formed to be excessively thin, the film quality of the first uppermost layer UL1 may be improved, and since the first uppermost layer UL1 is not formed to be excessively thick, the risk of undercut occurrence may be reduced, and mass productivity may be improved.

In addition, in the above-described embodiments, the thickness of the first lower layer LL1 of the first lower conductive layer BML1 may be in a range of about 77% or more to about 83% of the total thickness of the first lower conductive layer BML1. When the thickness of the first lower layer LL1 of the first lower conductive layer BML1 satisfies the above-described numerical range, since the overall thickness of the first lower conductive layer BML1 is not excessively thick, the problem that components positioned on the first lower conductive layer BML1 are disconnected due to a step difference caused by the first lower conductive layer BML1 may not occur.

In addition, in the above-described embodiments, the thickness of the lower titanium layer of the first lower conductive layer BML1 may be in a range of about 4.2% to about 5.1% of the total thickness of the first lower conductive layer BML1. When the thickness of the lower titanium layer of the first lower conductive layer BML1 satisfies the numerical range described above, the film quality of the lower titanium layer may be improved, the risk of undercut occurrence may be reduced, and mass productivity may be improved.

In an embodiment, where the second lower conductive layer BML2 has the triple-layer structure of titanium (Ti)/aluminium (Al)/titanium (Ti), the thickness t1 of the first uppermost layer UL1 of the second lower conductive layer BML2 may be in a range of about 200 angstroms to about 400 angstroms or in a range of about 250 angstroms to about 350 angstroms, or may be about 300 angstroms.

In the above-described embodiment, the thickness t1 of the first uppermost layer UL1 of the second lower conductive layer BML2 may be in a range of about 3% to about 11% of the total thickness of the second lower conductive layer BML2. When the thickness t1 of the first uppermost layer UL1 of the second lower conductive layer BML2 satisfies the numerical range described above, since the first uppermost layer UL1 is not formed to be excessively thin, the film quality of the first uppermost layer UL1 may be improved, and since the first uppermost layer UL1 is not formed to be excessively thick, the risk of undercut occurrence may be reduced, and mass productivity may be improved.

In addition, in the above-described embodiments, the thickness of the first lower layer LL1 of the second lower conductive layer BML2 may be in a range of about 85% to about 94% of the total thickness of the second lower conductive layer BML2. When the thickness of the first lower layer LL1 of the second lower conductive layer BML2 satisfies the above-described numerical range, since the overall thickness of the second lower conductive layer BML2 is not formed to be excessively thick, the problem that components positioned on the second lower conductive layer BML2 are disconnected due to a step difference caused by the second lower conductive layer BML2 may not occur.

In addition, in the above-described embodiments, the thickness of the lower titanium layer of the second lower conductive layer BML2 may be in a range of about 3.1% to about 4.3% of the total thickness of the second lower conductive layer BML2. When the thickness of the lower titanium layer of the second lower conductive layer BML2 satisfies the numerical range described above, the film quality of the lower titanium layer may be improved, the risk of undercut occurrence may be reduced, and mass productivity may be improved.

In an embodiment, where the second lower conductive layer BML2 has the triple-layer structure of titanium (Ti)/aluminium (Al)/titanium (Ti), the thickness t1 of the first uppermost layer UL1 of the second lower conductive layer BML2 may be in a range of about 400 angstroms to about 600 angstroms or in a range of about 450 angstroms to about 550 angstroms, or may be about 500 angstroms.

In the above-described embodiment, the thickness t1 of the first uppermost layer UL1 of the second lower conductive layer BML2 may be in a range of about 9% to about 14% of the total thickness of the second lower conductive layer BML2. When the thickness t1 of the first uppermost layer UL1 of the second lower conductive layer BML2 satisfies the numerical range described above, since the first uppermost layer UL1 is not formed to be excessively thin, the film quality of the first uppermost layer UL1 may be improved, and since the first uppermost layer UL1 is not formed to be excessively thick, the risk of undercut occurrence may be reduced, and mass productivity may be improved.

In addition, in the above-described embodiments, the thickness of the first lower layer LL1 of the second lower conductive layer BML2 may be in a range of about 82% to about 88% of the total thickness of the second lower conductive layer BML2. When the thickness of the first lower layer LL1 of the second lower conductive layer BML2 satisfies the above-described numerical range, since the overall thickness of the second lower conductive layer BML2 is not formed to be excessively thick, the problem that components positioned on the second lower conductive layer BML2 are disconnected due to a step difference caused by the second lower conductive layer BML2 may not occur.

In addition, in the above-described embodiments, the thickness of the lower titanium layer of the second lower conductive layer BML2 may be in a range of about 2.9% to about 4.1% of the total thickness of the second lower conductive layer BML2. When the thickness of the lower titanium layer of the second lower conductive layer BML2 satisfies the numerical range described above, the film quality of the lower titanium layer may be improved, the risk of undercut occurrence may be reduced, and mass productivity may be improved.

In an embodiment, as shown in FIG. 5, the second conductive layer CDL2 may include a second uppermost layer UL2 and a second lower layer LL2 disposed below the second uppermost layer UL2 and covered by the second uppermost layer UL2. In an embodiment, for example, the second conductive layer CDL2 may have a double-layer structure of titanium (Ti)/aluminium (Al). In such an embodiment, the second uppermost layer UL2 may be referred to as a second upper titanium layer, and the second lower layer LL2 may be referred to as a second lower aluminium layer. In another embodiment, for example, the second conductive layer CDL2 may have a triple-layer structure of titanium (Ti)/aluminium (Al)/titanium (Ti). In such an embodiment, the second uppermost layer UL2 may be referred to as a second upper titanium layer, the second lower layer LL2 may be referred to as a second lower aluminium layer, and a lower titanium layer not shown may be disposed below the second lower layer LL2. However, embodiments are not limited thereto. For example, embodiments of the disclosure may be applied to various cases in which the second conductive layer CDL2 includes a lower aluminium layer (for example, the second lower layer LL2) covered by an uppermost layer (for example, the second uppermost layer UL2), and the uppermost layer is disposed on the lower aluminium layer to serve as a capping layer for preventing hillocks or voids from occurring in the lower aluminium layer.

In an embodiment, where the second conductive layer CDL2 has the triple-layer structure of titanium (Ti)/aluminium (Al)/titanium (Ti) as described above, a thickness t2 of the second uppermost layer UL2, which is the second upper titanium layer, may be in a range of about 300 angstroms to about 800 angstroms or in a range of about 450 angstroms to about 650 angstroms, a thickness of the second lower layer LL2, which is the second lower aluminium layer, may be in a range of about 2,000 angstroms to about 3,000 angstroms or in a range of about 2,400 angstroms to about 2,600 angstroms, and a thickness of the lower titanium layer disposed below the second lower layer LL2 may be in a range of about 100 angstroms to about 200 angstroms.

In an embodiment, where the second conductive layer CDL2 has the triple-layer structure of titanium (Ti)/aluminium (Al)/titanium (Ti), the thickness t2 of the second uppermost layer UL2 of the second conductive layer CDL2 may be in a range of about 300 angstroms to about 800 angstroms or in a range of about 450 angstroms to about 550 angstroms, or about 500 angstroms.

In the above-described embodiments, the thickness t2 of the second uppermost layer UL2 may be in a range of about 13% to about 20% of the total thickness of the second conductive layer CDL2. When the thickness t2 of the second uppermost layer UL2 satisfies the numerical range described above, since the second uppermost layer UL2 is not formed to be excessively thin, the film quality of the second uppermost layer UL2 may be improved, and since the second uppermost layer UL2 is not formed to be excessively thick, the risk of undercut occurrence may be reduced, and mass productivity may be improved.

In addition, in the above-described embodiments, the thickness of the second lower layer LL2 may be in a range of about 75% to about 83% of the total thickness of the second conductive layer CDL2. When the thickness of the second lower layer LL2 satisfies the above-described numerical range, the overall thickness of the second conductive layer CDL2 is not excessively thick, and thus a problem that components disposed on the second conductive layer CDL2 are disconnected due to a step difference caused by the second conductive layer CDL2 may not occur.

In addition, in the above-described embodiments, the thickness of the lower titanium layer of the second conductive layer CDL2 may be in a range of about 4.2% to about 5% of the total thickness of the second conductive layer CDL2. When the thickness of the lower titanium layer of the second conductive layer CDL2 satisfies the numerical range described above, the film quality of the lower titanium layer may be improved, the risk of undercut occurrence may be reduced, and mass productivity may be improved.

In an embodiment, each of third conductive layer CDL3 and the fourth conductive layer CDL4 may be provided to be substantially identical (or similar) to the first conductive layer CDL1 and the second conductive layer CDL2 described above, but embodiments of the disclosure are not limited thereto. In another embodiment, for example, at least one of the third conductive layer CDL3 and the fourth conductive layer CDL4 may have a single layer structure including one of various known conductive materials.

In an embodiment of the disclosure, the third conductive layer CDL3 may be connected to (or in electrical contact with) each of the first conductive layer CDL1, the second conductive layer CDL2, and a semiconductor layer SCL.

In an embodiment, the third conductive layer CDL3 may be connected to the first conductive layer CDL1 through a first contact hole CNT1 that passes through an insulating layer array INSA and exposes at least a portion of the first conductive layer CDL1. In an embodiment, the first contact hole CNT1 may be defined (or formed) to pass through a second insulating layer INS2 and a first insulating layer INS1. In such an embodiment, as shown in FIG. 6, the first contact hole CNT1 may expose a first portion p11 of the first uppermost layer UL1 (hereinafter, will be referred to as "1-1 portion"), and the third conductive layer CDL3 may be disposed to fill the first contact hole CNT1 and connected to (or in electrical contact with) the 1-1 portion p11. Here, a second portion p12 of the first uppermost layer UL1 (hereinafter, will be referred to as "1-2 portion") may be a portion thereof other than the 1-1 portion p11. In an embodiment, an upper surface of the 1-2 portion p12 may not be in contact with the third conductive layer CDL3 and may be covered by the first insulating layer INS1.

In an embodiment, the third conductive layer CDL3 may be connected to the second conductive layer CDL2 through a second contact hole CNT2 that passes through the insulating layer array INSA and exposes at least a portion of the second conductive layer CDL2. In an embodiment, the second contact hole CNT2 may be defined (or formed) to pass through the second insulating layer INS2. In this case, as shown in FIG. 5, the second contact hole CNT2 may expose a first portion p21 of the second uppermost layer UL2 (hereinafter, will be referred to as "2-1 portion"), and the third conductive layer CDL3 may be disposed to fill the second contact hole CNT2 and connected to (or in electrical contacted with) the 2-1 portion p21. Here, a second portion p22 of the 2nd uppermost layer UL2 (hereinafter, will be referred to as "2-2 portion") may be a portion thereof other than the 2-1 portion p21. In an embodiment, an upper surface of the 2-2 portion p22 may not be in contact with the third conductive layer CDL3 and may be covered by the second insulating layer INS2.

In an embodiment, the third conductive layer CDL3 may be connected to the semiconductor layer SCL through a third contact hole CNT3 that passes through the insulating layer array INSA and exposes at least a portion of the semiconductor layer SCL. In an embodiment, the third contact hole CNT3 may be defined (or formed) to pass through the second insulating layer INS2. In this case, the third conductive layer CDL3 may be disposed to fill the third contact hole CNT3 and connected to (or electrical contacted with) the semiconductor layer SCL.

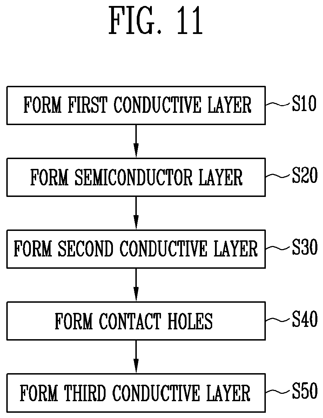

In an embodiment, the contact holes CNT1, CNT2, and CNT3 formed (or defined) in the insulating layer array INSA may be simultaneously formed at different positions through a single mask process (or example, a same dry etching process using a single mask), and since the third conductive layer CDL3 is formed on the insulating layer array INSA later to fill the contact holes CNT1, CNT2, and CNT3, the third conductive layer CDL3 may be connected to (or in contact with) the first conductive layer CDL1, the second conductive layer CDL2, and the semiconductor layer SCL. This single mask process will be described in detail below with reference to FIGS. 11 to 18.

When the above-described single mask process is performed, since the first conductive layer CDL1 and the second conductive layer CDL2 are disposed in different layers (or at different levels), a depth D1 of the first contact hole CNT1 in a first direction DR1 may be formed to be greater than a depth D2 of the second contact hole CNT2 in the first direction DR1. In an embodiment, for example, a difference between the depth D1 of the first contact hole CNT1 and the depth D2 of the second contact hole CNT2 may be in a range of about 2,000 angstroms to about 6,000 angstroms. Accordingly, when the above-described single mask process is performed, the second uppermost layer UL2 of the second conductive layer CDL2 may be relatively over-etched as compared to the first uppermost layer UL1 of the first conductive layer CDL1. In this case, when a thickness of the second uppermost layer UL2 in the first direction DR1 is set to be substantially equal (or similar) to a thickness of the first uppermost layer UL1 in the first direction DR1 before the above-described single mask process is performed, as the second uppermost layer UL2 is over-etched while the above-described single mask process is performed, the second lower layer LL2 may be exposed through the second contact hole CNT2. When the second lower layer LL2 is exposed, the contact resistance of a contact surface between the second conductive layer CDL2 and the third conductive layer CDL3 may increase due to oxidation of the second lower layer LL2 (for example, an aluminium layer), which may deteriorate the display quality of a display device. In this way, when the second uppermost layer UL2 is over-etched and the second lower layer LL2 is exposed through the second contact hole CNT2, contact resistance may be, for example, about 3.57 ohms.

In order to prevent the above-described contact resistance from being excessively increasing, in an embodiment, a thickness t2 of the 2-2 portion p22 may be greater than a thickness t1 of the 1-2 portion p12. That is, a thickness of an uppermost layer (for example, the 2-2 part p22 of the second uppermost layer UL2) of a conductive layer (for example, the second conductive layer CDL2) that is closer to the third conductive layer CDL3 in the first direction DR1 may be set relatively great. Accordingly, in the single mask process described above, an uppermost layer included in each of conductive layers may be effectively prevented from being over-etched to expose a lower layer below the uppermost layer.

In an embodiment, as shown in FIG. 5, the thickness t2 of the 2-2 portion p22 in the first direction DR1 may be greater than a thickness t2' of the 2-1 portion p21 in the first direction DR1. In this case, a second recessed portion GR2 having a depth d2 corresponding to a difference (that is, t2-t2') between the thickness t2 of the 2-2 portion p22 and the thickness t2' of the 2-1 portion p21 may be defined (or formed) in the second uppermost layer UL2.

This may be because, when the above-described single mask process is performed, even though the formation of the second contact hole CNT2 is completed, dry etching may be performed for an additional time to complete the formation of the first contact hole CNT1 having a depth D1 greater than the depth D2 of the second contact hole CNT2, and during the additional time, damage due to the dry etching accumulates in the second conductive layer CDL2 positioned closer to the third conductive layer CDL3 than the first conductive layer CDL1, resulting in over-etching of the second uppermost layer UL2. That is, when the above-described single mask process is performed, an over-etched portion of the second uppermost layer UL2 may be a portion corresponding to the second recessed portion GR2.

In an embodiment, as shown in FIG. 6, the thickness t1 of the 1-2 portion p12 in the first direction DR1 may be greater than a thickness t1' of the 1-1 portion p11 in the first direction DR1. In such an embodiment, a first recessed portion GR1 having a depth d1 corresponding to a difference (that is, t1-t1') between the thickness t1 of the 1-2 portion p12 and the thickness t1' of the 1-1 portion p11 may be defined (or formed) in the first uppermost layer UL1. Here, when the above-described single mask process is performed, an over-etched portion of the first uppermost layer UL1 may be a portion corresponding to the first recessed portion GR1.

In another embodiment, the 1-1 portion p11 may not be over-etched when the above-described single mask process is performed. In an embodiment, for example, by appropriately controlling a time for which dry etching is performed during the single mask process described above, the first uppermost layer UL1 may be effectively prevented from being substantially damaged by the dry etching. In such an embodiment, the first recessed portion GR1 may not be defined (or formed) in the first uppermost layer UL1. In an embodiment, the thickness t1' of the 1-1 portion p11 may be substantially equal to the thickness t1 of the 1-2 portion p12.

In an embodiment, the second uppermost layer UL2 may be over-etched as compared to the first uppermost layer UL1 as described above (or since the second uppermost layer UL2 receives more cumulative damage by dry etching as compared to the first uppermost layer UL1, the depth d2 of the second recessed portion GR2 defined in the second uppermost layer UL2 may be greater than the depth d1 of the first recessed portion GR1 defined in the first uppermost layer UL1.

In an embodiment, a difference (for example, d2-d1) between the depth d2 of the second recessed portion GR2 and the depth d1 of the first recessed portion GR1 may be proportional to a ratio (for example, ER1:ER2) of an etching rate (ER1) of the second uppermost layer UL2 to an average etching rate (ER2) of over-etched portions of insulating layers (for example, the second insulating layer INS2 and the first insulating layer INS1) in an etching process (for example, a dry etching process of the same mask process described above). In an embodiment, the ratio (for example, ER1:ER2) may be about 1:8. Here, the over-etched portions of the insulating layers may refer to portions of the insulating layers positioned between an upper surface of the first conductive layer CDL1 and a upper surface of the second conductive layer CDL2 among the insulating layers included in the insulating layer array INSA. The over-etched portions may refer to portions etched during a period from the completion of formation of the second contact hole CNT2 to the completion of formation of the first contact hole CNT1 in a single mask process of simultaneously forming the first and second contact holes CNT1 and CNT2.

In an embodiment, the thickness t2 of the 2-2 portion p22 may be a thickness that may be set such that the thickness t2' of the 2-1 portion p21 is greater than or equal to about 10 angstroms. Accordingly, it is possible to effectively prevent an increase in contact resistance of a contact surface between the third conductive layer CDL3 and the second conductive layer CDL2 due to the second uppermost layer UL2 being over-etched by the above-described single mask process. In an embodiment, for example, the contact resistance of the contact surface between the third conductive layer CDL3 and the second conductive layer CDL2 may be less than or equal to about 1 ohm.

In an embodiment, the thickness t1 of the 1-2 portion p12 may be set such that the thickness t1' of the 1-1 portion p11 is greater than or equal to about 10 angstroms. Accordingly, an increase in contact resistance of a contact surface between the third conductive layer CDL3 and the first conductive layer CDL1 may be effectively prevented.

As described above, in an embodiment of the disclosure, the first and second uppermost layers UL1 and UL2 included in the first and second conductive layers CDL1 and CDL2 may effectively serve to prevent exposure of the first and second lower layers LL1 and LL2. Accordingly, the first lower layer LL1 may not be exposed by the first contact hole CNT1, and the second lower layer LL2 may not be exposed by the second contact hole CNT2.

In such an embodiment, an electrical connection between the third conductive layer CDL3 and the first lower layer LL1 may be made through the first uppermost layer UL1 which is in electrical contact with each of the third conductive layer CDL3 and the first lower layer LL1. That is, the third conductive layer CDL3 may not be in direct contact with the first lower layer LL1.

In such an embodiment, an electrical connection between the third conductive layer CDL3 and the second lower layer LL2 may be made through the second uppermost layer UL2 which is in electrical contact with each of the third conductive layer CDL3 and the second lower layer LL2. That is, the third conductive layer CDL3 may not be in direct contact with the second lower layer LL2.

In an embodiment, the thickness t1' of the 1-1 portion p11 may have a value substantially equal or similar to the thickness t2' of the 2-1 portion p21. In an embodiment, for example, the thickness t1' of the 1-1 portion p11 may be in a range of about 90% to about 110% of the thickness t2' of the 2-1 portion p21.

In an embodiment, the thickness t2' of the 2-1 portion p21 may be in a range of about 10 angstroms to about 500 angstroms. When the thickness t2' of the 2-1 portion p21 satisfies the numerical range described above, the second uppermost layer UL2 may effectively serve as a capping layer that effectively prevents hillocks or voids from occurring in the second lower layer LL2, and also, manufacturing costs for forming the second uppermost layer UL2 may be effectively reduced. In this case, the thickness t2' of the 2-1 portion p21 may be, for example, in a range of about 0.5% to about 13.5% of the total thickness of the second conductive layer CDL2.

In an embodiment, the contact holes CNT1, CNT2, and CNT3 may be formed through a contact hole formation process (that is, the above-described single mask process) after the formation of the insulating layer array INSA is completed. In other words, separate contact holes may not be formed before the formation of the insulating layer array INSA is completed. In this case, in an embodiment, the first conductive layer CDL1, the second conductive layer CDL2, and the semiconductor layer SCL disposed on different layers may not be in direct contact with each other.

In an embodiment, an electrical connection between the first conductive layer CDL1, the second conductive layer CDL2, and the semiconductor layer SCL disposed on different layers may be made at least through the third conductive layer CDL3.

In an embodiment, for example, where the first conductive layer CDL1 and the semiconductor layer SCL are electrically connected to each other, an electrical connection path between the first conductive layer CDL1 and the semiconductor layer SCL may include at least a portion of the third conductive layer CDL3. In other words, the first conductive layer CDL1 and the semiconductor layer SCL may not be electrically connected without the third conductive layer CDL3.

In another embodiment, for example, where the first conductive layer CDL1 and the second conductive layer CDL2 are electrically connected to each other, an electrical connection path between the first conductive layer CDL1 and the second conductive layer CDL2 may include at least a portion of the third conductive layer CDL3. In other words, the first conductive layer CDL1 and the second conductive layer CDL2 may not be electrically connected without the third conductive layer CDL3.

In an embodiment, although not shown in FIGS. 4 to 6, the fourth conductive layer CDL4 may be connected to (or in electrical contact with) the third conductive layer CDL3. For example, in some regions, a contact hole (not shown) exposing at least a portion of the third conductive layer CDL3 may be defined (or formed) in a first via layer VIA1, and the fourth conductive layer CDL4 may be connected to (or electrical contact with) the third conductive layer CDL3 through the contact hole (not shown).

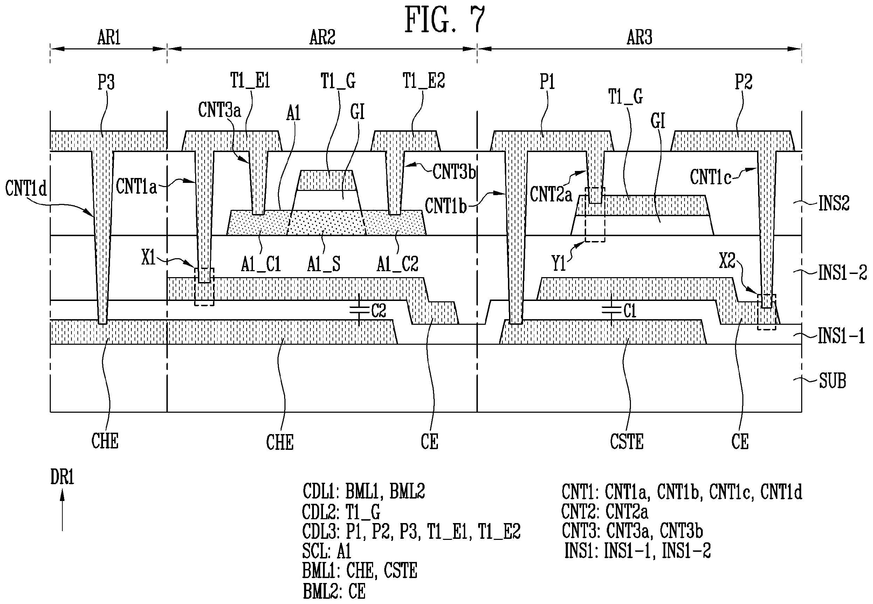

FIG. 7 is a cross-sectional view illustrating an embodiment in which a first transistor, a first capacitor, and a second capacitor of FIG. 2 are implemented by conductive layers shown in FIGS. 3 to 6. In FIG. 7, for convenience of illustration and description, a first via layer VIA1 and components disposed on the first via layer VIA1 are omitted.

Referring to FIG. 7, a first region AR1, a second region AR2, and a third region AR3 may each independently be a partial region of a region in which the pixel circuit PXCij described with reference to FIG. 2 is disposed.

An insulating layer array INSA (see FIG. 3) may include a first insulating layer INS1, a gate insulating layer GI, and a second insulating layer INS2. The first insulating layer INS1 may include a 1-1 insulating layer INS1-1 and a 1-2 insulating layer INS1-2. The 1-1 insulating layer INS1-1, the 1-2 insulating layer INS1-2, the gate insulating layer GI, and the second insulating layer INS2 may be substantially the same as those described above with reference to FIGS. 3 to 6. Therefore, any repetitive descriptions thereof will be omitted.

A first conductive layer CDL1 may include a first lower conductive layer BML1 and a second lower conductive layer BML2.

The first lower conductive layer BML1 may be patterned into preset shapes. In an embodiment, patterned portions of the first lower conductive layer BML1 may include (or define) a first lower capacitor electrode CSTE and a second lower capacitor electrode CHE. In such an embodiment, each of the first lower capacitor electrode CSTE and the second lower capacitor electrode CHE may be provided similarly to the first conductive layer CDL1 described with reference to FIGS. 3 to 6.

Each of the first lower capacitor electrode CSTE and the second lower capacitor electrode CHE may be positioned between a substrate SUB and the 1-1 insulating layer INS1-1.

The first lower capacitor electrode CSTE may serve as the first terminal of the first capacitor C1 described with reference to FIG. 2. The first lower capacitor electrode CSTE may be disposed in the third region AR3.

The second lower capacitor electrode CHE may serve as the first terminal of the second capacitor C2 described with reference to FIG. 2. The second lower capacitor electrode CHE may be disposed in the first region AR1 and the second region AR2.

The first lower capacitor electrode CSTE and the second lower capacitor electrode CHE may be separated from each other. That is, the first lower capacitor electrode CSTE and the second lower capacitor electrode CHE may not be in direct contact with each other.

The second lower conductive layer BML2 may be patterned into preset shapes. In an embodiment, patterned portions of the second lower conductive layer BML2 may include an upper capacitor electrode CE. In such an embodiment, the upper capacitor electrode CE may be provided similarly to the first conductive layer CDL1 described with reference to FIGS. 3 to 6.

The upper capacitor electrode CE may be disposed between the 1-1 insulating layer INS1-1 and the 1-2 insulating layer INS1-2. The upper capacitor electrode CE may be disposed directly on the first insulating layer INS1-1.

The upper capacitor electrode CE may overlap the first lower capacitor electrode CSTE in the third region AR3 in the first direction DR1. In such an embodiment, the upper capacitor electrode CE in the third region AR3 may serve as the second terminal of the first capacitor C1 described with reference to FIG. 2.

In an embodiment, the upper capacitor electrode CE may overlap the second lower capacitor electrode CHE in the second region AR2 in the first direction DR1. In such an embodiment, the upper capacitor electrode CE in the second region AR2 may serve as the second terminal of the second capacitor C2 described with reference to FIG. 2.

In an embodiment, in FIG. 7, the upper capacitor electrode CE is illustrated as being positioned in each of the second region AR2 and the third region AR3. However, the upper capacitor electrode CE positioned in the second region AR2 and the upper capacitor electrode CE positioned in the third region AR3 may be connected to each other and formed integrally with each other as a single unitary indivisible part by extending to another region not shown in FIG. 7.

The semiconductor layer SCL may be patterned into preset shapes. In an embodiment, patterned portions of the semiconductor layer SCL may include a first semiconductor pattern A1. In such an embodiment, the first semiconductor pattern A1 may be provided similarly to the semiconductor layer SCL described with reference to FIGS. 3 to 6.

A portion of the first semiconductor pattern A1 may be disposed between the 1-2 insulating layer INS1-2 and the gate insulating layer GI. The first semiconductor pattern A1 may be disposed directly on the 1-2 insulating layer INS1-2.

The first semiconductor pattern A1 may include a first semiconductor portion A1_S and a first conductor portion A1_C1 and a second conductor portion A1_C2 which are adjacent to both opposing sides of the first semiconductor portion A1_S.

The first conductor portion A1_C1 and the second conductor portion A1_C2 may be portions having relatively high conductivity in the first semiconductor pattern A1. In an embodiment, for example, the first conductive portion A1_C1 and the second conductive portion A1_C2 may be portions that become conductive by being exposed to etching particles during a dry etching process of patterning the second conductive layer CDL2. In such an embodiment, the first conductor portion A1_C1 and the second conductor portion A1_C2 may serve as electrodes, interconnects, or the like.

In an embodiment, the first conductor portion A1_C1 may serve as the first electrode of the first transistor T1 described with reference to FIG. 2. In addition, the second conductor portion A1_C2 may serve as the second electrode of the first transistor T1 described with reference to FIG. 2.

The first semiconductor portion A1_S may have semiconductor properties. In an embodiment, for example, the first semiconductor portion A1_S may be a portion that is substantially not exposed to etching particles during a dry etching process of patterning the second conductive layer CDL2. In such an embodiment, the first semiconductor portion A1_S may serve as a channel of the transistor. Specifically, the first semiconductor portion A1_S may serve as a channel of the first transistor T1.

In an embodiment, the first semiconductor pattern A1 may be disposed in the second region AR2. In such an embodiment, the upper capacitor electrode CE overlapping the first semiconductor portion A1_S in the second region AR2 in the first direction DR1 may serve as the second gate electrode of the first transistor T1 described with reference to FIG. 2.

The second conductive layer CDL2 may be patterned into preset shapes. In an embodiment, patterned portions of the second conductive layer CDL2 may include a first gate electrode pattern T1_G. In this case, the first gate electrode pattern T1_G may be provided similarly to the second conductive layer CDL2 described with reference to FIGS. 3 to 6.

The first gate electrode pattern T1_G may be disposed between the gate insulating layer GI and the second insulating layer INS2. The first gate electrode pattern T1_G may be disposed directly on the gate insulating layer GI.

The first gate electrode pattern T1_G may overlap the first semiconductor portion A1_S in the second region AR2 in the first direction DR1. In such an embodiment, the first gate electrode pattern T1_G in the second region AR2 may serve as the first gate electrode of the first transistor T1 described with reference to FIG. 2.

In an embodiment, the first gate electrode pattern T1_G may also be disposed in the third region AR3. In such an embodiment, the first gate electrode pattern T1_G in the third region AR3 may not overlap the semiconductor layer SCL in the first direction DR1. In an embodiment, the first gate electrode pattern T1_G disposed in the second region AR2 and the first gate electrode pattern T1_G disposed in the third region AR3 may be formed integrally with each other as a single unitary indivisible part by extending to another region not shown in FIG. 7 to be connected to each other.

The third conductive layer CDL3 may be patterned into preset shapes. In an embodiment, patterned portions of the third conductive layer CDL3 may include a first pattern P1, a second pattern P2, a third pattern P3, a first electrode pattern T1_E1, and a second electrode pattern T1_E2. In such an embodiment, each of the first pattern P1, the second pattern P2, the third pattern P3, the first electrode pattern T1_E1, and the second electrode pattern T1_E2 may be provided similarly to the third conductive layer CDL3 described with reference to FIGS. 3 to 6.

Each of the first pattern P1, the second pattern P2, the third pattern P3, the first electrode pattern T1_E1, and the second electrode pattern T1_E2 may be positioned between the second insulating layer INS2 and a first via layer VIA1 (see FIG. 3) not shown in FIG. 6.

The first electrode pattern T1_E1 may be connected to (or in electrical contact with) the first conductor portion A1_C1 in the second region AR2 through a third contact hole CNT3a. In addition, the first electrode pattern T1_E1 may be connected to (or in electrical contact with) the upper capacitor electrode CE in the second region AR2 through a first contact hole CNT1a. Here, the first contact hole CNT1a and the third contact hole CNT3a may be formed similarly to the first contact hole CNT1 and the third contact hole CNT3 described with reference to FIGS. 4 to 6, respectively. Accordingly, the first conductor portion A1_C1 and the upper capacitor electrode CE may be electrically connected to each other through the first electrode pattern T1_E1. In such an embodiment, the first electrode pattern T1_E1 may define the second node N2 described with reference to FIG. 2.

The second electrode pattern T1_E2 may be in electrical contact with the second conductor portion A1_C2 in the second region AR2 through a third contact hole CNT3b. Here, the third contact hole CNT3b may be formed similarly to the third contact hole CNT3 described with reference to FIGS. 4 to 6. In such an embodiment, the second electrode pattern T1_E2 may extend to another region not shown in FIG. 7 and electrically connected to the second electrode (not shown) of the fifth transistor T5 described with reference to FIG. 2.

The first pattern P1 may be in electrical contact with the first gate electrode pattern T1_G in the third region AR3 through a second contact hole CNT2a. In addition, the first pattern P1 may be in electrical contact with the first lower capacitor electrode CSTE in the third region AR3 through a first contact hole CNT1b. Here, the first contact hole CNT1b and the second contact hole CNT2a may be formed similarly to the first contact hole CNT1 and the second contact hole CNT2 described with reference to FIGS. 4 to 6. Accordingly, the first gate electrode pattern T1_G and the first lower capacitor electrode CSTE may be electrically connected to each other through the first pattern P1. In such an embodiment, the first pattern P1 may define the first node N1 described with reference to FIG. 2.

The second pattern P2 may be in electrical contact with the upper capacitor electrode CE in the third region AR3 through a first contact hole CNT1c. Here, the first contact hole CNT1c may be formed similarly to the first contact hole CNT1 described with reference to FIGS. 4 to 6. In such an embodiment, the second pattern P2 may extend to the other region not shown in FIG. 7 and electrically connected to the first electrode (not shown) of the sixth transistor T6 described with reference to FIG. 2.

The third pattern P3 may be in electrical contact with the second lower capacitor electrode CHE in the first region AR1 through a first contact hole CNT1d. Here, the first contact hole CNT1d may be formed similarly to the first contact hole CNT1 described with reference to FIGS. 4 to 6. In such an embodiment, the third pattern P3 may serve as the first power line ELVDDL described with reference to FIG. 2 or may be electrically connected to the first power line ELVDDL described with reference to FIG. 2.

In an embodiment, the first pattern P1, the second pattern P2, the third pattern P3, the first electrode pattern T1_E1, and the second electrode pattern T1_E2 may be separated from each other. That is, the first pattern P1, the second pattern P2, the third pattern P3, the first electrode pattern T1_E1, and the second electrode pattern T1_E2 may not be in direct contact with each other.

In an embodiment, as shown in FIG. 7, the first conductive layer CDL1, the second conductive layer CDL2, and the semiconductor layer SCL may not be in direct contact with each other. In such an embodiment, an electrical connection between the first conductive layer CDL1, the second conductive layer CDL2, and the semiconductor layer SCL may be made at least through the third conductive layer CDL3.

In an embodiment, for example, an electrical connection between the upper capacitor electrode CE and the first conductor portion A1_C1 may be made through the first electrode pattern T1_E1. In another embodiment, for example, an electrical connection between the first gate electrode pattern T1_G and the first lower capacitor electrode CSTE may be made through the first pattern P1.

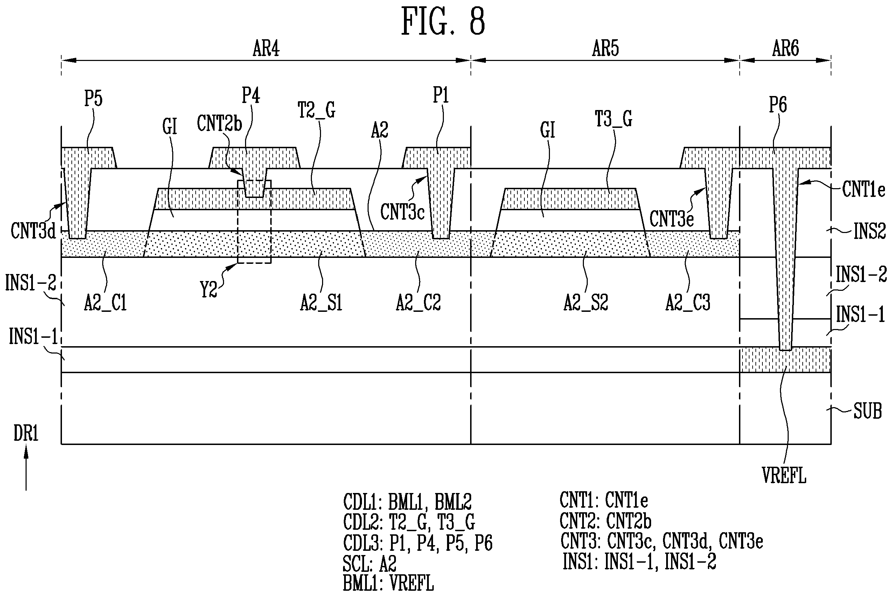

FIG. 8 is a cross-sectional view illustrating an embodiment in which a second transistor and a third transistor of FIG. 2 are implemented by conductive layers shown in FIGS. 3 to 6. In FIG. 8, for convenience of illustration and description, a first via layer VIA1 and components disposed on the first via layer VIA1 are omitted. Hereinafter, any repetitive detailed descriptions of the same or like elements as those described with reference to FIG. 7 may be omitted.

Referring to FIG. 8, a fourth region AR4, a fifth region AR5, and the sixth region AR6 may each independently be a partial region of a region in which the pixel circuit PXCij described with reference to FIG. 2 is disposed.

In an embodiment, a first lower conductive layer BML1 of a first conductive layer CDL1 may be patterned into preset shapes. In an embodiment, patterned portions of the first lower conductive layer BML1 may include a reference voltage transmission line VREFL. In such an embodiment, the reference voltage transmission line VREFL may be provided similarly to the first conductive layer CDL1 described with reference to FIGS. 3 to 6.

The reference voltage transmission line VREFL may be disposed between a substrate SUB and a first insulating layer INS1-1. The reference voltage transmission line VREFL may be a pattern to which the reference voltage is applied as described with reference to FIG. 2. In an embodiment, for example, the reference voltage transmission line VREFL may be electrically connected to a reference voltage source (not shown) by extending to the other region not shown in FIG. 8.

A semiconductor layer SCL may be patterned into preset shapes. In an embodiment, patterned portions of the semiconductor layer SCL may include a second semiconductor pattern A2. In such an embodiment, the second semiconductor pattern A2 may be provided similarly to the semiconductor layer SCL described with reference to FIGS. 3 to 6.

A portion of the second semiconductor pattern A2 may be disposed between a 1-2 insulating layer INS1-2 and a gate insulating layer GI. The second semiconductor pattern A2 may be disposed directly on the 1-2 insulating layer INS1-2.

The second semiconductor pattern A2 may include a first semiconductor portion A2_S1, a second semiconductor portion A2_S2, a first conductor portion A2_C1, a second conductor portion A2_C2, and a third conductor portion A2_C3.

The first semiconductor portion A2_S1 may have semiconductor properties. The first semiconductor portion A2_S1 may be positioned between the first conductor portion A2_C1 and the second conductor portion A2_C2 in the fourth region AR4. The first semiconductor portion A2_S1 may serve as a channel of the second transistor T2 described with reference to FIG. 2.

The second semiconductor portion A2_S2 may have semiconductor properties. The second semiconductor portion A2_S2 may be positioned between the second conductor portion A2_C2 and the third conductor portion A2_C3 in the fifth region AR5. The second semiconductor portion A2_S2 may serve as a channel of the third transistor T3 described with reference to FIG. 2.

The first conductor portion A2_C1 may be a portion having relatively high conductivity. The first conductor portion A2_C1 may be disposed adjacent to the first semiconductor portion A2_S1 in the fourth region AR4. The first conductor portion A2_C1 may serve as the first electrode of the second transistor T2 described with reference to FIG. 2.

The second conductor portion A2_C2 may be a portion having relatively high conductivity. The second conductor portion A2_C2 may be disposed in the fourth region AR4 and the fifth region AR5. The second conductor portion A2_C2 may be disposed adjacent to the first semiconductor portion A2_S1 in the fourth region AR4 and may be disposed adjacent to the second semiconductor portion A2_S2 in the fifth region AR5. The second conductor portion A2_C2 may serve as the second electrode of the second transistor T2 described with reference to FIG. 2 in the fourth region AR4 and may serve as the second electrode of the third transistor T3 described with reference to FIG. 2 in the fifth region AR5.

In an embodiment, the first semiconductor portion A2_S1 and the second semiconductor portion A2_S2 may be spaced apart from each other. In this case, the first semiconductor portion A2_S1 and the second semiconductor portion A2_S2 may be electrically connected to each other by the second conductor portion A2_C2. Here, the second conductor portion A2_C2 may serve as an interconnect that electrically connects the second electrode of the second transistor T2 and the second electrode of the third transistor T3 described with reference to FIG. 2.

The third conductor portion A2_C3 may be a portion having relatively high conductivity. The third conductor portion A2_C3 may be disposed adjacent to the second semiconductor portion A2_S2 in the fifth region AR5. The third conductor portion A2_C3 may serve as the first electrode of the third transistor T3 described with reference to FIG. 2 in the fifth region AR5.

In an embodiment, a second conductive layer CDL2 may be patterned into preset shapes. Patterned portions of the second conductive layer CDL2 may include a second gate electrode pattern T2_G and a third gate electrode pattern T3_G. In such an embodiment, each of the second gate electrode pattern T2_G and the third gate electrode pattern T3_G may be provided similarly to the second conductive layer CDL2 described with reference to FIGS. 3 to 6.

Each of the second gate electrode pattern T2_G and the third gate electrode pattern T3_G may be positioned between the gate insulating layer GI and a second insulating layer INS2. Each of the second gate electrode pattern T2_G and the third gate electrode pattern T3_G may be disposed directly on the gate insulating layer GI.

The second gate electrode pattern T2_G may overlap the first semiconductor portion A2_S1 in the fourth region AR4. In this case, the second gate electrode pattern T2_G in the fourth region AR4 may serve as the gate electrode of the second transistor T2 described with reference to FIG. 2.

In an embodiment, the third gate electrode pattern T3_G may overlap the second semiconductor portion A2_S2 in the fifth region AR5 in the first direction DR1. In such an embodiment, the third gate electrode pattern T3_G in the fifth region AR5 may serve as the gate electrode of the third transistor T3 described with reference to FIG. 2.

In an embodiment, a third conductive layer CDL3 may be patterned into preset shapes. Patterned portions of the third conductive layer CDL3 may include a first pattern P1, a fourth pattern P4, a fifth pattern P5, and a sixth pattern P6. In such an embodiment, each of the first pattern P1, the fourth pattern P4, the fifth pattern P5, and the sixth pattern P6 may be provided similarly to the third conductive layer CDL3 described with reference to FIGS. 3 to 6.

Each of the first pattern P1, the fourth pattern P4, the fifth pattern P5, and the sixth pattern P6 may be positioned between the second insulating layer INS2 and a first via layer VIA1 (see FIG. 3) not shown in FIG. 6.

The first pattern P1 is a pattern disposed in the third region AR3 described with reference to FIG. 7 and may also be disposed in the fourth region AR4 by extending from the third region AR3 to the other region not shown in FIGS. 7 and 8. The first pattern P1 may be connected to (or in electrical contact with) the second conductor portion A2_C2 in the fourth region AR4 through a third contact hole CNT3c. Here, the third contact hole CNT3c may be formed similarly to the third contact hole CNT3 described with reference to FIGS. 4 to 6. Accordingly, the second conductor portion A2_C2 may be electrically connected to the first gate electrode pattern T1_G and the first lower capacitor electrode CSTE described with reference to FIG. 7 through the first pattern P1.

The fourth pattern P4 may be connected to (or in electrical contact with) the second gate electrode pattern T2_G through the first contact hole CNT1e in the fourth region AR4. Here, the first contact hole CNT1e may be formed similarly to the first contact hole CNT1 described with reference to FIGS. 4 to 6.

The fifth pattern P5 may be connected to (or electrical contact with) the first conductor portion A2_C1 in the fourth region AR4 through a third contact hole CNT3d. Here, the third contact hole CNT3d may be formed similarly to the third contact hole CNT3 described with reference to FIGS. 4 to 6. The fifth pattern P5 may serve as the data line DLj described with reference to FIG 2, or may serve as an interconnect that electrically connects the data line DLj to the first conductor portion A2_C1.

The sixth pattern P6 may be in electrical contact with the third conductor portion A2_C3 in the fifth region AR5 through a third contact hole CNT3e. In addition, the sixth pattern P6 may be in electrical contact with the reference voltage transmission line VREFL in the sixth region AR6 through the first contact hole CNT1e. Here, the first contact hole CNT1e and the third contact hole CNT3e may be formed similarly to the first contact hole CNT1 and the third contact hole CNT3 described with reference to FIGS. 4 to 6, respectively. Accordingly, the third conductor portion A2_C3 and the reference voltage transmission pattern VREFL may be electrically connected to each other through the sixth pattern P6.

In an embodiment, the first pattern P1, the fourth pattern P4, the fifth pattern P5, and the sixth pattern P6 may be separated from each other. That is, the first pattern P1, the fourth pattern P4, the fifth pattern P5, and the sixth pattern P6 may not be in direct contact with each other.

In an embodiment, as shown in FIG. 8, the first conductive layer CDL1, the second conductive layer CDL2, and the semiconductor layer SCL may not be in direct contact with each other. In this case, an electrical connection between the first conductive layer CDL1, the second conductive layer CDL2, and the semiconductor layer SCL may be made at least through the third conductive layer CDL3. For example, an electrical connection between the third conductor portion A2_C3 and the reference voltage transmission line VREFL may be made through the sixth pattern P6.

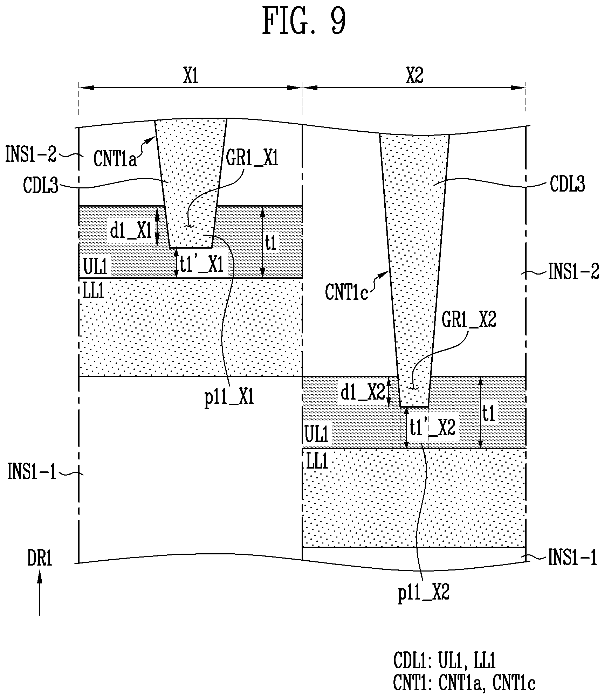

FIG. 9 is an enlarged view of region X1 and the region X2 of FIG. 7.

Referring to FIG. 9, in some regions, the second lower conductive layer BML2 may be disposed to overlap the first lower conductive layer BML1 in the first direction DR1, and in other regions, the second lower conductive layer BML2 may be disposed to not overlap the first lower conductive layer BML1 in the first direction DR1.

In an embodiment, for example, in one region X1, the upper capacitor electrode CE may be disposed to overlap the second lower capacitor electrode CHE in the first direction DR1, but in the other region X2, the upper capacitor electrode CE may not overlap the first lower capacitor electrode CSTE in the first direction DR1. Accordingly, a portion of the upper capacitor electrode CE disposed in one region X1 may be disposed above a portion of the upper capacitor electrode CE disposed in the other region X2.

In an embodiment, one region portion of the first conductive layer CDL1 disposed in one region X1 (for example, a portion of the upper capacitor electrode CE of the second lower conductive layer BML2 disposed in one region X1) may be disposed above the other region portion of the first conductive layer CDL1 disposed in the other region X2 (for example, a portion of the upper capacitor electrode CE of the second lower conductive layer BML2 disposed in the other region X2. Accordingly, a depth d1_X1 of a first recessed portion GR1_X1 defined in the first uppermost layer UL1 of one region portion of the first conductive layer CDL1 in one region X1 may be greater than a depth d1_X2 of a first recessed portion GR1_X2 defined in the first uppermost layer UL1 of the other region portion of the first conductive layer CDL1 in the other region X2.

In such an embodiment, features of a thickness t1'_X1 of a 1-1 portion p11_X1 in one region X1 and a thickness t1'_X1 of a 1-1 portion p11_X2 in the other region X2 may be substantially the same as those of the thickness t1' of the 1-1 portion p11 described with reference to FIGS. 4 to 6. In an embodiment, for example, the thickness t1'_X1 of the 1-1 portion p11_X1 in one region X1 and the thickness t1'_X1 of the 1-1 portion p11_X2 in other region X2 may each be about 10 angstroms or greater. In such an embodiment, the thickness t1'_X1 of the 1-1 portion p11_X1 in one region X1 may be less than the thickness t1'_X1 of the 1-1 portion p11_X2 in the other region X2.

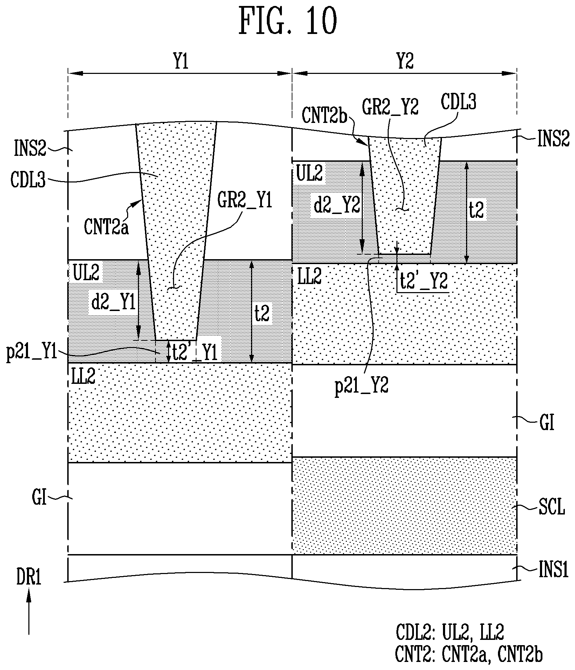

FIG. 10 is an enlarged view of region Y1 of FIG. 7 and region Y2 of FIG. 8.

Referring to FIG. 10, in some regions, the second conductive layer CDL2 may be disposed to not overlap the semiconductor layer SCL in the first direction DR1, and in other regions, the second conductive layer CDL2 may be disposed to overlap the semiconductor layer SCL in the first direction DR1.

In an embodiment, for example, in one region Y2, the second gate electrode pattern T2_G may be disposed to overlap the second semiconductor pattern A2 in the first direction DR1, but in the other region Y1, the first gate electrode pattern T1_G may be disposed to not overlap the first semiconductor pattern A1 in the first direction DR1. Accordingly, a portion of the first gate electrode pattern T1_G disposed in one region Y2 may be disposed above a portion of the second gate electrode pattern T2_G disposed in the other region Y1.

In an embodiment, one region portion (for example, the second gate electrode pattern T2_G) of the second conductive layer CDL2 disposed in one region Y2 may be disposed above the other region portion (for example, the first gate electrode pattern T1_G) of the second conductive layer CDL2 disposed in the other region Y1. Accordingly, a depth d2_Y2 of a second recessed portion GR2_Y2 defined in the second uppermost layer UL2 of one region portion of the second conductive layer CDL2 in one region Y2 may be greater than a depth d2_Y1 of a second recessed portion GR2_Y1 defined in the second uppermost layer UL2 of the other region portion of the second conductive layer CDL2 in the other region Y1.

In such an embodiment, features of a thickness t2'_Y2 of a 2-1 portion p21_Y2 in one region Y2 and a thickness t2'_Y1 of a 2-1 portion p21_Y1 in other region Y1 may be substantially the same as those of the thickness t2' of the 2-1 portion p21 with reference to FIGS. 4 to 6. In an embodiment, for example, the thickness t2'_Y2 of the 2-1 portion p21_Y2 in one region Y2 and the thickness t2'_Y1 of the 2-1 portion p21_Y1 in other region Y1 may each be about 10 angstroms or greater. In such an embodiment, the thickness t2'_Y2 of the 2-1 part p21_Y2 in one region Y2 may be less than the thickness t2'_Y1 of the 2-1 part p21_Y1 in other region Y1.

FIGS. 11 to 18 are views for describing a method of manufacturing a display device according to an embodiment of the disclosure. Hereinafter, any repetitive detailed descriptions of the same or like elements as those described above with reference to FIGS. 1 to 10 will be omitted or simplified.

Referring to FIG. 11, the method of manufacturing a display device according to an embodiment of the disclosure may include a series of operations of forming a first conductive layer (S10), forming a semiconductor layer (S20), forming a second conductive layer (S30), forming contact holes (S40), and forming a third conductive layer (S50).

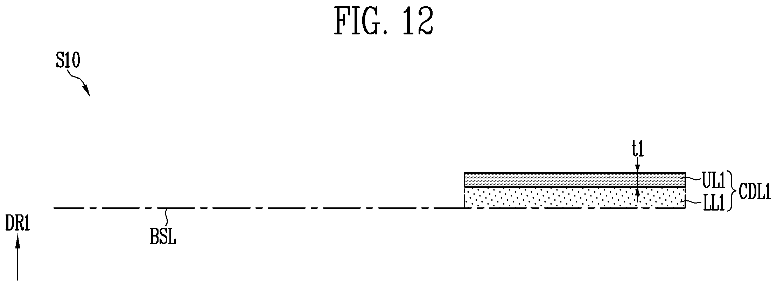

Hereinafter, the method of manufacturing a display device according to an embodiment of the disclosure of FIG. 11 will be described in greater detail with reference to FIGS. 12 to 18.

Referring to FIG. 12, in the method of manufacturing a display device according to an embodiment of the disclosure, a first conductive layer CDL1 may be formed (S10).

The first conductive layer CDL1 may include a first lower layer LL1 and a first uppermost layer UL1 covering at least an upper surface of the first lower layer LL1. In operation S10, a thickness of the first uppermost layer UL1 in a first direction DR1 may correspond to the thickness t1 of the 1-2 portion p12 described with reference to FIG. 6.

In an embodiment, operation S10 may include, after entirely forming the first conductive layer CDL1 on a base layer BSL, a patterning process of patterning the first conductive layer CDL1.

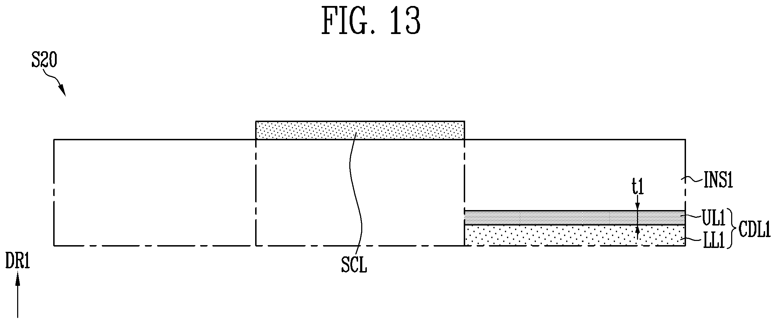

Referring to FIG. 13, a semiconductor layer SCL may be formed (S20). Operation S20 may include, before forming the semiconductor layer SCL, forming a first insulating layer INS1 covering the first conductive layer CDL1.

In an embodiment, operation S20 may include, entirely forming the semiconductor layer SCL on the first insulating layer INS1, a patterning process of patterning the semiconductor layer SCL.

In an embodiment, in operation S20, the semiconductor layer SCL and the first conductive layer CDL1 may not be in direct contact with each other. In an embodiment, for example, the first insulating layer INS1 may be disposed between the semiconductor layer SCL and the first conductive layer CDL1.

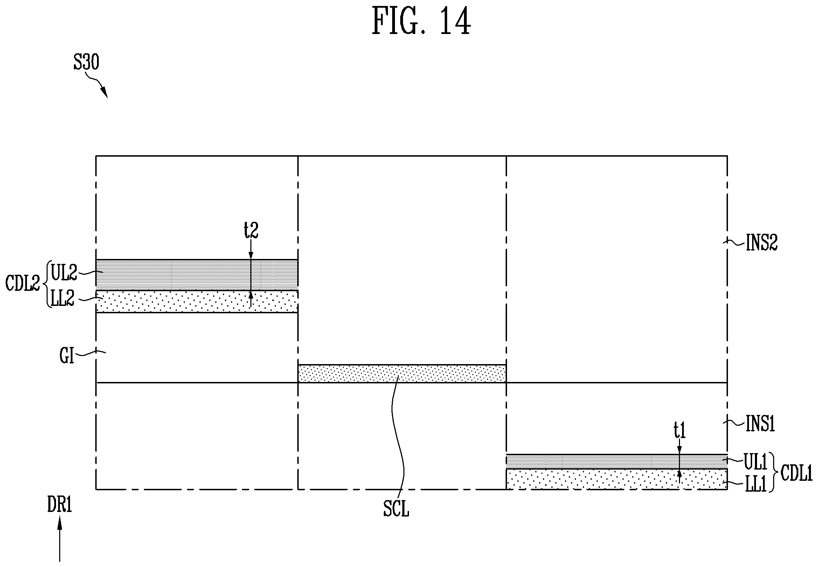

Referring to FIG. 14, a second conductive layer CDL2 may be formed (S30). Operation S30 may include, before forming the second conductive layer CDL2, forming a gate insulating layer GI.

The second conductive layer CDL2 may include a second lower layer LL2 and a second uppermost layer UL2 covering at least an upper surface of the second lower layer LL2. In operation S30, a thickness of the second uppermost layer UL2 in the first direction DR1 may correspond to the thickness t2 of the 2-2 portion p22 described with reference to FIG. 5.

In an embodiment, operation S30 may include, after entirely forming the gate insulating layer GI and the second conductive layer CDL2 entirely on the first insulating layer INS1 and the semiconductor layer SCL, a patterning process of patterning the second conductive layer CDL2 and the gate insulating layer GI.

In an embodiment, in the patterning process of patterning the second conductive layer CDL2 and the gate insulating layer GI, at least a portion of the semiconductor layer SCL that does not overlap the second conductive layer CDL2 and the gate insulating layer GI in the first direction DR1 may be exposed. In such an embodiment, a portion of the exposed semiconductor layer SCL may have relatively high conductivity.

In such an embodiment, even when a portion of the semiconductor layer SCL is exposed, the semiconductor layer SCL may not be in direct contact with the second conductive layer CDL2. In an embodiment, for example, at least the gate insulating layer GI may be disposed between the semiconductor layer SCL and the second conductive layer CDL2.

In operation S30, the first conductive layer CDL1, the semiconductor layer SCL, and the second conductive layer CDL2 may not be in direct contact with each other. In an embodiment, for example, at least the first insulating layer INS1 may be disposed between the semiconductor layer SCL and the first conductive layer CDL1. In an embodiment, for example, at least the gate insulating layer GI may be disposed between the semiconductor layer SCL and the second conductive layer CDL2. In an embodiment, for example, at least the gate insulating layer GI and first insulating layer INS1 may be disposed between the second conductive layer CDL2 and the first conductive layer CDL1.

In an embodiment, operation S30 may further include forming a second insulating layer INS2 covering the semiconductor layer SCL, the gate insulating layer GI, and the second conductive layer CDL2 on the first insulating layer INS1.

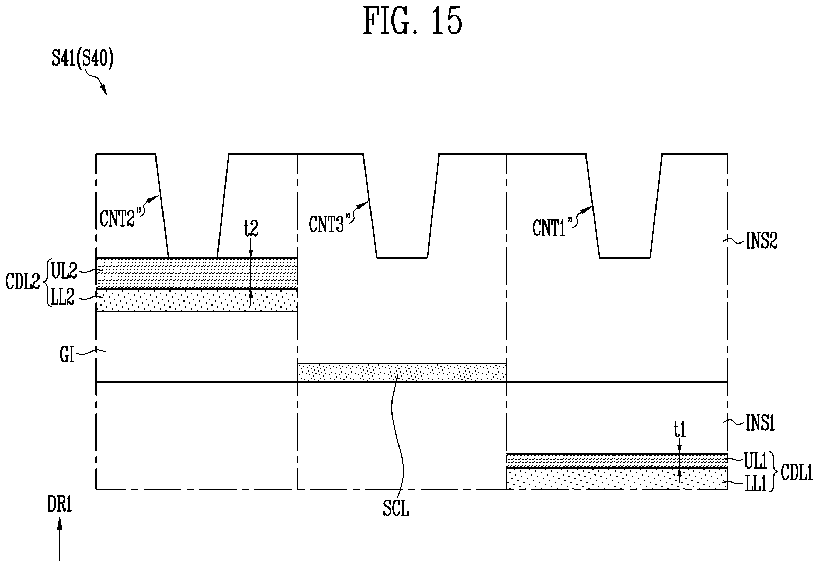

Referring to FIGS. 15 to 17, contact holes CNT1, CNT2, and CNT3 may be formed (S40). In an embodiment, the contact holes CNT1, CNT2, and CNT3 may be formed simultaneously at different positions through a single mask process. In an embodiment, operation S40 may include first operation S41, second operation S42, and third operation S43.

Referring to FIG. 15, a first contact hole CNT1", a second contact hole CNT2", and a third contact hole CNT3" may be formed (S41).

In an embodiment, in first operation S41, the second contact hole CNT2" may expose at least a portion of the second uppermost layer UL2.

In an embodiment, in first operation (S41), depths of the first contact hole CNT1", the second contact hole CNT2", and the third contact hole CNT3" in the first direction DR1 may be equal to each other.

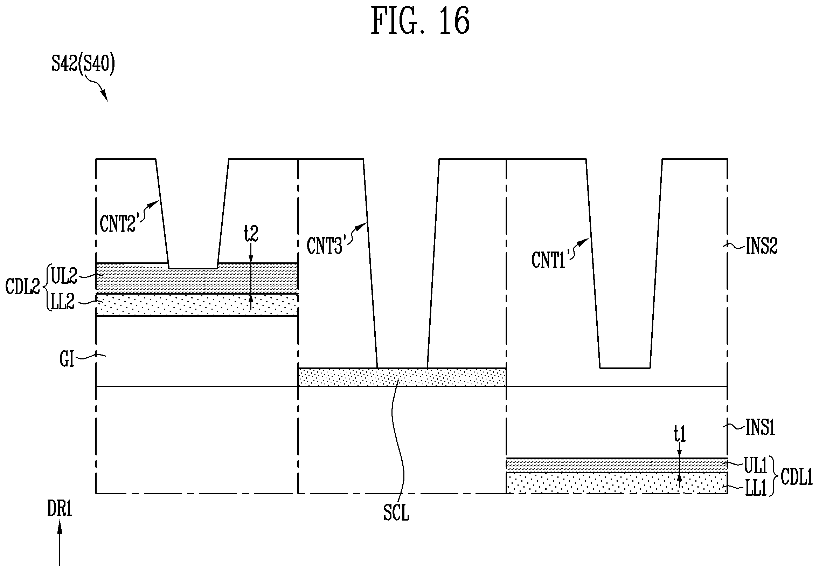

Referring to FIG. 16, additional etching (for example, dry etching) may be performed after first operation S41, thereby forming a first contact hole CNT1', a second contact hole CNT2', and a third contact hole CNT3' (S42).

In an embodiment, in second operation S42, the third contact hole CNT3' may expose at least a portion of the semiconductor layer SCL.

In an embodiment, in second operation S42, depths of the first contact hole CNT1' and the third contact hole CNT3' in the first direction DR1 may be equal to each other.

In an embodiment, in second operation S42, a portion of the second uppermost layer UL2 may be over-etched, thereby forming a recessed portion in a portion corresponding to a portion of the second uppermost layer UL2 exposed by the second contact hole CNT2'.

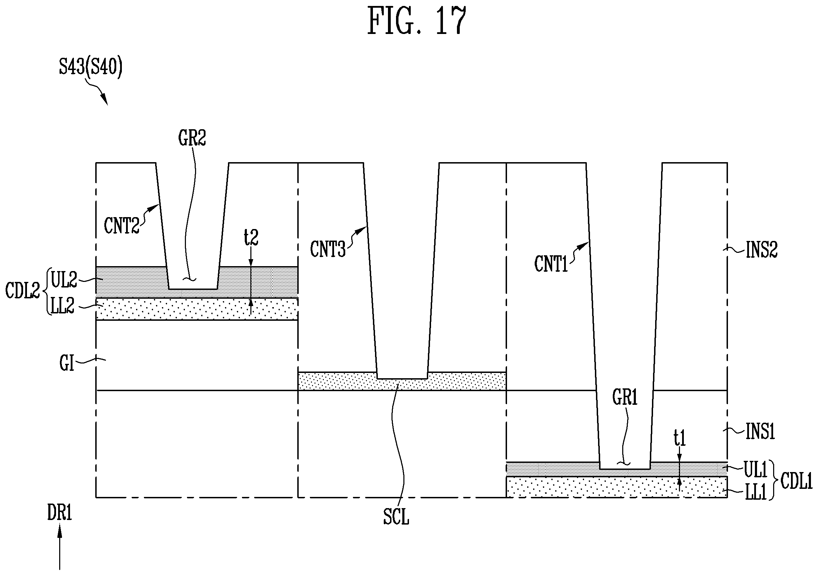

Referring to FIG. 17, additional etching (for example, dry etching) may be performed after second operation S42, thereby forming a first contact hole CNT1, a second contact hole CNT2, and a third contact hole CNT3 (S43).

In an embodiment, in third operation S43, the first contact hole CNT1 may expose at least a portion of the first uppermost layer UL1.

In an embodiment, in third operation S43, a portion of the second uppermost layer UL2 may be further over-etched as compared to second operation S42, and thus a second recessed portion GR2 corresponding to a portion of the second uppermost layer UL2 exposed by the second contact hole CNT2 may be formed.

In an embodiment, in third operation S43, a portion of the first uppermost layer UL1 may be over-etched. In such an embodiment, a first recessed portion GR1 corresponding to a portion of the first uppermost layer UL1 exposed by the first contact hole CNT1 may be formed. Alternatively, in another embodiment, in third operation S43, a portion of the first uppermost layer UL1 may not be substantially over-etched. In such an embodiment, the first recessed portion GR1 may not be formed substantially in the first uppermost layer UL1.

Referring again to FIGS. 15 to 17, the contact holes CNT1, CNT2, and CNT3 may be formed simultaneously at different positions through a same etching process. Accordingly, manufacturing efficiency may be improved.

Since the contact holes CNT1, CNT2, and CNT3 are formed through a same etching process, the second conductive layer CDL2, which is positioned at an uppermost side among the first conductive layer CDL1, the second conductive layer CDL2, and the semiconductor layer SCL, may receive relatively more cumulative damage due to etching. That is, the second conductive layer CDL2 may be over-etched. In addition, the first conductive layer CDL1, which is positioned at a lowermost side among the first conductive layer CDL1, the second conductive layer CDL2, and the semiconductor layer SCL, may receive relatively less cumulative damage due to etching.

In such an embodiment, since the second uppermost layer UL2 may have a relatively great thickness t2 as described with reference to FIGS. 1 to 10, the second uppermost layer UL2 may effectively protect the second lower layer LL2 from accumulated damage due to etching. That is, the second lower layer LL2 may not be exposed by the second contact hole CNT2. In an embodiment, for example, as described with reference to FIG. 5, a thickness t2' of a 2-1 portion p21 may be about 10 angstroms or greater.

In such an embodiment, the first uppermost layer UL1 may have an appropriate thickness t1 to protect the first lower layer LL1 from cumulative damage due to etching. Therefore, the first lower layer LL1 may not be exposed by the first contact hole CNT1. In an embodiment, for example, as described with reference to FIG. 6, a thickness t1' of a 1-1 portion p11 may be about 10 angstroms or greater.

In an embodiment, in operation S40, the first conductive layer CDL1, the second conductive layer CDL2, and the semiconductor layer SCL may not be in direct contact with each other. That is, in operation S40, the first conductive layer CDL1, the second conductive layer CDL2, and the semiconductor layer SCL may be electrically insulated from each other.

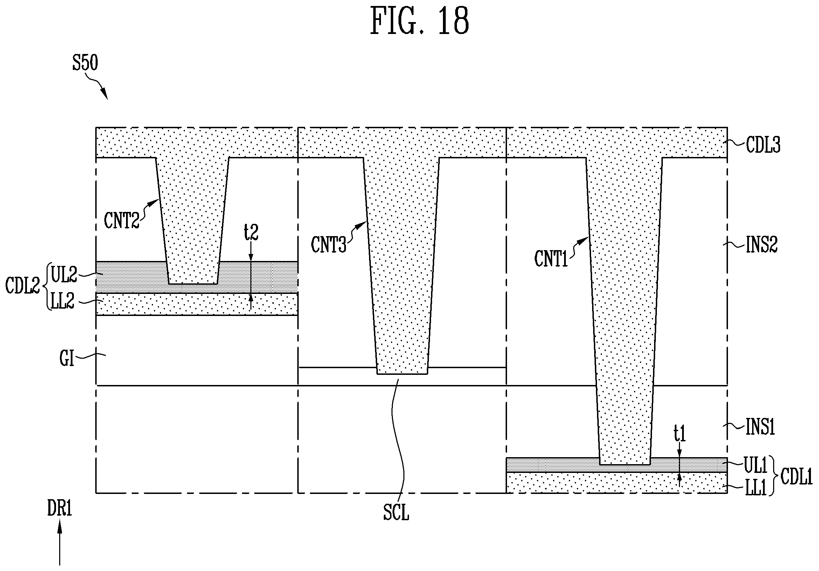

Referring to FIG. 18, a third conductive layer CDL3 may be formed (S50).

In operation S50, the third conductive layer CDL3 may fill the first contact hole CNT1, and thus the third conductive layer CDL3 may be connected to (or in electrical contact with) the first conductive layer CDL1. In such an embodiment, the third conductive layer CDL3 may fill the second contact hole CNT2 and the third contact hole CNT3, and thus the third conductive layer CDL3 may be connected to (or in electrical contact with) each of the second conductive layer CDL2 and the semiconductor layer SCL.

In an embodiment, operation S50 may include, entirely forming the third conductive layer CDL3 on the second insulating layer INS2, a patterning process of patterning the third conductive layer CDL3.

In an embodiment, in operation S50, the third conductive layer CDL3 may provide an electrical connection path for electrically connecting the first conductive layer CDL1, the second conductive layer CDL2, and the semiconductor layer SCL to each other.

In an embodiment, for example, as shown in FIG. 7, an electrical connection between a first lower capacitor electrode CSTE and a first gate electrode pattern T1_G may be made by a first pattern P1.

In an embodiment, for example, as shown in FIG. 7, an electrical connection between an upper capacitor electrode CE and a first conductor portion A1_C1 may be made through a first electrode pattern T1_E1.

In such an embodiment, as described above, after operation S50 is performed, the first conductive layer CDL1, the second conductive layer CDL2, and the semiconductor layer SCL may be electrically connected to each other at least through the third conductive layer CDL3. In an embodiment, where the third conductive layer CDL3 is not present, the first conductive layer CDL1, the second conductive layer CDL2, and the semiconductor layer (ATV) may not be electrically connected to each other.

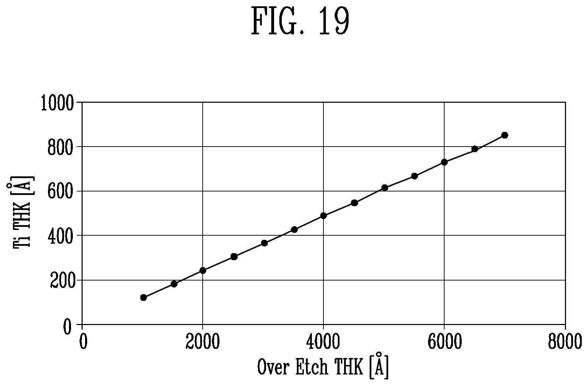

FIG. 19 is a graph for describing a thickness of a second uppermost layer to prevent an excessive increase in contact resistance between a second conductive layer and a third conductive layer, according to a thickness of over-etched portions of insulating layers.

Referring to FIG. 19, an X-axis of the graph of FIG. 19 may represent the thickness of the over-etched portions of the insulating layers, and a Y-axis of the graph of FIG. 19 may represent the thickness t2 of the second uppermost layer UL2 to prevent an excessive increase in contact resistance between the second conductive layer CDL2 and the third conductive layer CDL3.

Here, the over-etched portions of the insulating layers may refer to portions of the insulating layers INS1 and INS2 positioned between a lowermost surface of the first contact hole CNT1" and an upper surface of the first uppermost layer UL1 in first operation S41 shown in FIG. 15. That is, the over-etched portions of the insulating layers may refer to portions of the insulating layers positioned between an upper surface of the first conductive layer CDL1 and an upper surface of the second conductive layer CDL2 among the insulating layers included in the insulating layer array INSA.

In addition, the thickness t2 of the second uppermost layer UL2 required to prevent an excessive increase in contact resistance of the second conductive layer CDL2 and the third conductive layer CDL3 may refer to a thickness in which the thickness t2' of the 2-1 portion p21 shown in FIG. 5 may be about 10 Angstroms or more when the first to third contact holes CNT1, CNT2, and CNT3 are simultaneously formed through a single mask process.

In an embodiment, the thickness t2 of the 2-2 portion p22 may be set to a thickness in which the thickness t2' of the 2-1 portion p21 may be about 10 angstroms or greater based on a degree of over-etching of the second uppermost layer UL2 with respect to the first uppermost layer UL1. Here, the degree of over-etching of the second uppermost layer UL2 with respect to the first uppermost layer UL1 may refer to a difference between a depth d2 (see FIG. 5) of the second recessed portion GR2 and a depth d1 (see FIG. 6) of the first recessed portion GR1. In such a case, the degree of over-etching of the second uppermost layer UL2 with respect to the first uppermost layer UL1 may be substantially proportional to the thickness of the over-etched portions of the insulating layers as shown in FIG. 19. Accordingly, in the case described above, the difference between the depth d2 of the second recessed portion GR2 and the depth d1 of the first recessed portion GR1 may be generally proportional to a difference between a depth D1 of the first contact hole CNT1 and a depth D2 of the second contact hole CNT2.

In an embodiment, each of the thicknesses t1 and t2 of the first and second uppermost layers UL1 and UL2 may be set not to be excessively great in consideration of manufacturing costs and manufacturing time. In an embodiment, where each of the first and second uppermost layers UL1 and UL2 is a titanium layer, the thickness t1 of the first uppermost layer UL1 may be about 300 angstroms. In such an embodiment, for example, the thickness t2 of the second uppermost layer UL2 may be about 500 angstroms, which is greater than the thickness t1 of the first uppermost layer UL1, based on the thickness of the over-etched portion of the insulating layers (for example, the X-axis of the graph of FIG. 19).

In an embodiment, as described above, the thickness t2 of the second uppermost layer UL2 may be set based on a difference between the depth D1 of the first contact hole CNT1 and the depth D2 of the second contact hole CNT2, and a ratio of an etching rate of the second uppermost layer UL2 to an average etching rate of the insulating layers between the first conductive layer CDL1 and the second conductive layer CDL2.

In embodiments of the disclosure, the embodiments of the disclosure are not limited to first to third conductive layers CDL1, CDL2, and CDL3 described above. In any three conductive layers that constitute a pixel circuit PXCij and are disposed on different layers (or at different levels), all conductive layers in which both of two conductive layers at a lower side are connected to (or in electrical contact with) another conductive layer thereon through contact holes formed to pass through the insulating layers may correspond to the first to third conductive layers CDL1, CDL2, and CDL3 described herein.

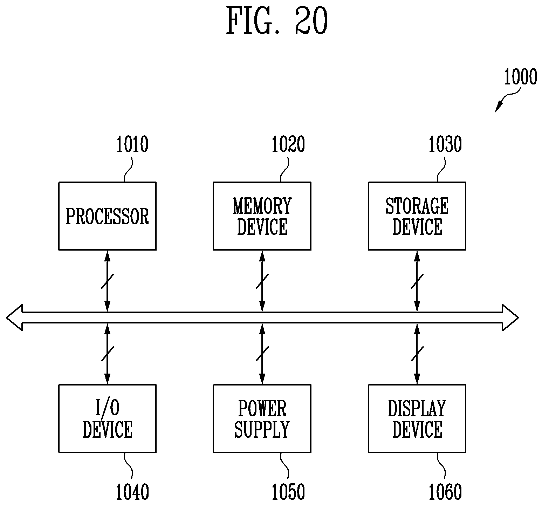

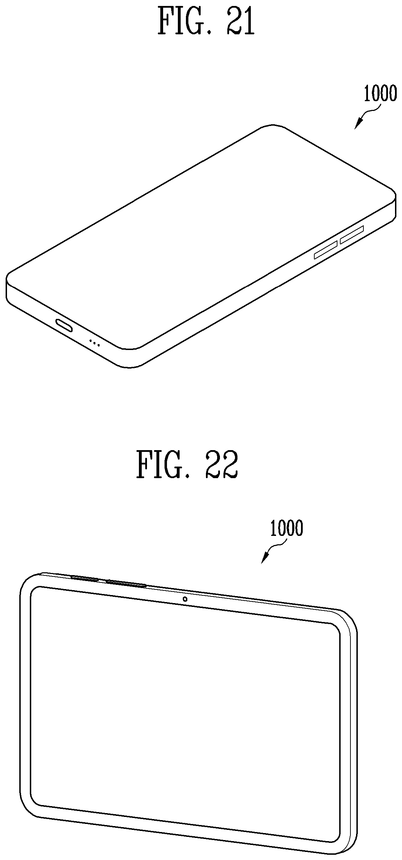

FIG. 20 is a view for describing an electronic apparatus including a display device of the disclosure. FIG. 21 is a view illustrating an example in which the electronic apparatus of FIG. 20 is implemented as a smartphone. FIG. 22 is a view illustrating an embodiment in which the electronic apparatus of FIG. 20 is implemented as a tablet personal computer (PC).

Referring to FIGS. 20 to 22, an embodiment of an electronic apparatus 1000 may include a processor 1010, a memory device 1020, a storage device 1030, an input/output device 1040, a power supply 1050, and a display device 1060. The display device 1060 may be the display device 10 described with reference to FIGS. 1 to 19. In addition, the electronic apparatus 1000 may further include various ports that may communicate with a video card, a sound card, a memory card, a universal serial bus (USB) device, or the like, or may communicate with other systems. In an embodiment, as shown in FIG. 21, the electronic apparatus 1000 may be implemented as a smartphone. In another embodiment, as shown in FIG. 22, the electronic apparatus 1000 may be implemented as a tablet PC. However, this is merely an example, and the electronic apparatus 1000 is not limited to the above-described embodiments. In an embodiment, for example, the electronic apparatus 1000 may be implemented as a mobile phone, a video phone, a smart pad, a smart watch, a vehicle navigation device, a computer monitor, a head mounted display device, or the like.

The processor 1010 may perform specific calculations or tasks. According to embodiments, the processor 1010 may be a microprocessor, a central processing unit, an application processor, or the like. The processor 1010 may be connected to other components through an address bus, a control bus, and a data bus. According to embodiments, the processor 1010 may also be connected to an expansion bus such as a peripheral component interconnect (PCI) bus. According to embodiments, the processor 1010 may provide input image data to the display device 1060, and accordingly, the display device 1060 may display an image based on the input image data provided from the processor 1010.

The memory device 1020 may store data necessary for the operation of the electronic apparatus 1000. In an embodiment, for example, the memory device 1020 may include non-volatile memory devices such as an erasable programmable read-only memory (EPROM) device, an electrically erasable programmable read-only memory (EEPROM) device, a flash memory device, a phase change random access memory (PRAM) device, a resistance random access memory (RRAM) device, a nano-floating gate memory (NFGM) device, a polymer random access memory (PoRAM) device, a magnetic random access memory (MRAM) device, and a ferroelectric random access memory (FRAM) device, and/or volatile memory devices such as a dynamic random access memory (DRAM) device, a static random access memory (SRAM) device, and a mobile DRAM device.

The storage device 1030 may include a solid state drive (SSD), a hard disk drive (HDD), a CD-ROM, or the like.

The input/output device 1040 may include an input means such as a keyboard, a keypad, a touchpad, a touch screen, or a mouse and an output means such as a speaker or a printer. According to embodiments, the input/output device 1040 may be implemented integrally with the display device 1060.

The power supply 1050 may supply power necessary for the operation of the electronic apparatus 1000. In an embodiment, for example, the power supply 1050 may be a power management integrated circuit (PMIC). According to embodiments, the power supply 1050 may supply power to the display device 1060.

The display device 1060 may display an image corresponding to visual information of the electronic apparatus 1000. The display device 1060 may be connected to other components through the buses or other communication links.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the spirit or scope of the invention as defined by the following claims.

## Claims

1. A display device comprising:
a substrate;
a first conductive layer disposed on the substrate and including a first uppermost layer and a first lower layer below the first uppermost layer;
a first insulating layer disposed on the substrate to cover the first conductive layer;
a gate insulating layer disposed on the first insulating layer;
a second conductive layer disposed on the gate insulating layer and including a second uppermost layer and a second lower layer below the second uppermost layer;
a second insulating layer disposed on the first insulating layer to cover the second conductive layer; and
a third conductive layer disposed on the second insulating layer and connected to each of the first conductive layer and the second conductive layer through a first contact hole and a second contact hole,
wherein the first contact hole is defined through the first insulating layer and the second insulating layer to expose a first portion of the first uppermost layer,
the second contact hole is defined through the second insulating layer to expose a first portion of the second uppermost layer,
the third conductive layer is disposed in the first contact hole and the second contact hole and is in contact with the first portion of the first uppermost layer and the first portion of the second uppermost layer,
an upper surface of a second portion of the first uppermost layer is not in contact with the third conductive layer,
an upper surface of a second portion of the second uppermost layer is not in contact with the third conductive layer,
a thickness of the second portion of the second uppermost layer is greater than a thickness of the first portion of the second uppermost layer, and
a thickness of the second portion of the first uppermost layer is greater than or equal to a thickness of the first portion of the first uppermost layer.

2. The display device of claim 1, wherein the thickness of the second portion of the second uppermost layer is greater than the thickness of the second portion of the first uppermost layer.

3. The display device of claim 1, wherein the thickness of the second portion of the second uppermost layer is in a range of about 300 angstroms to about 800 angstroms, and
the thickness of the second portion of the first uppermost layer is in a range of about 100 angstroms to about 700 angstroms.

4. The display device of claim 3, wherein each of the first uppermost layer and the second uppermost layer includes titanium, and
each of the first lower layer and the second lower layer includes aluminium.

5. The display device of claim 4, wherein a difference between a depth of the first contact hole and a depth of the second contact hole is in a range of about 2,000 angstroms to about 6,000 angstroms.

6. The display device of claim 1, wherein a first depth is defined as a difference between the thickness of the second portion of the first uppermost layer and the thickness of the first portion of the first uppermost layer,
a second depth is defined as a difference between the thickness of the second portion of the second uppermost layer and the thickness of the first portion of the second uppermost layer, and
the second depth is greater than the first depth.

7. The display device of claim 6, wherein a difference between the second depth and the first depth is proportional to a ratio of an etching rate of the second uppermost layer to an average etching rate of insulating layers between the first conductive layer and the second conductive layer in a dry etching.

8. The display device of claim 6, wherein a difference between the second depth and the first depth is proportional to a difference between a depth of the first contact hole and a depth of the second contact hole.

9. The display device of claim 1, wherein the thickness of the first portion of the second uppermost layer is about 10 angstroms or greater.

10. The display device of claim 9, wherein a contact resistance of a contact surface between the third conductive layer and the second conductive layer is about 1 ohm or less.

11. The display device of claim 1, further comprising a semiconductor layer disposed between the gate insulating layer and the first insulating layer,
wherein the third conductive layer is connected to the semiconductor layer through a contact hole defined through the second insulating layer, and
the semiconductor layer includes polycrystalline silicon, monocrystalline silicon, low-temperature polycrystalline silicon, amorphous silicon, or an oxide semiconductor.

12. The display device of claim 1, wherein the thickness of the second portion of the first uppermost layer is in a range of about 3% to about 18% of a total thickness of the first conductive layer.

13. The display device of claim 1, wherein the thickness of the second portion of the second uppermost layer is in a range of about 13% to about 20% of a total thickness of the second conductive layer, and
the thickness of the first portion of the second uppermost layer is about 0.5% or greater of the total thickness of the second conductive layer.

14. A display device comprising:
a substrate;
a first conductive layer disposed on the substrate and including a first upper titanium layer and a first lower aluminium layer;
a first insulating layer disposed on the substrate to cover the first conductive layer;
a gate insulating layer disposed on the first insulating layer;
a second conductive layer disposed on the gate insulating layer and including a second upper titanium layer and a second lower aluminium layer;
a second insulating layer disposed on the first insulating layer to cover the second conductive layer; and
a third conductive layer disposed on the second insulating layer and connected to each of the first conductive layer and the second conductive layer through a first contact hole and a second contact hole,
wherein the first contact hole is defined through the first insulating layer and the second insulating layer to expose a first portion of the first upper titanium layer,
the second contact hole is defined through the second insulating layer to expose a first portion of the second upper titanium layer,
the third conductive layer is disposed in the first contact hole and the second contact hole and is in contact with the first portion of the first upper titanium layer and the first portion of the second upper titanium layer,
an upper surface of a second portion of the first upper titanium layer is not in contact with the third conductive layer,
an upper surface of a second portion of the second upper titanium layer is not in contact with the third conductive layer,
a thickness of the second portion of the second upper titanium layer is greater than a thickness of the first portion of the second upper titanium layer, and
a thickness of the second portion of the first upper titanium layer is greater than or equal to a thickness of the first portion of the first upper titanium layer.

15. The display device of claim 14, wherein the thickness of the second portion of the second upper titanium layer is greater than the thickness of the second portion of the first upper titanium layer.

16. The display device of claim 14, wherein the thickness of the second portion of the second upper titanium layer is in a range of about 300 angstroms to about 800 angstroms, and
the thickness of the second portion of the first upper titanium layer is in a range of about 100 angstroms to about 700 angstroms.

17. The display device of claim 14, wherein a difference between a depth of the first contact hole and a depth of the second contact hole is in a range of about 2,000 angstroms to about 6,000 angstroms.

18. The display device of claim 14, wherein a first depth is defined as a difference between the thickness of the second portion of the first upper titanium layer and the thickness of the first portion of the first upper titanium layer,
a second depth is defined as a difference between the thickness of the second portion of the second upper titanium layer and the thickness of the first portion of the second upper titanium layer, and
the second depth is greater than the first depth.

19. The display device of claim 18, wherein a difference between the second depth and the first depth is proportional to a ratio of an etching rate of the second upper titanium layer to an average etching rate of insulating layers between the first conductive layer and the second conductive layer in a dry etching.

20. The display device of claim 18, wherein a difference between the second depth and the first depth is proportional to a difference between a depth of the first contact hole and a depth of the second contact hole.

21. The display device of claim 14, wherein the thickness of the first portion of the second upper titanium layer is about 10 angstroms or greater.

22. The display device of claim 21, wherein a contact resistance of a contact surface between the third conductive layer and the second conductive layer is about 1 ohm or less.

23. The display device of claim 14, further comprising a semiconductor layer disposed between the gate insulating layer and the first insulating layer,
wherein the third conductive layer is connected to the semiconductor layer through a contact hole defined through the second insulating layer, and
the semiconductor layer includes polycrystalline silicon, monocrystalline silicon, low-temperature polycrystalline silicon, amorphous silicon, or an oxide semiconductor.

24. The display device of claim 14, wherein a ratio of the thickness of the second portion of the first upper titanium layer to a total thickness of the first conductive layer is in a range of about 3% to about 18%.

25. The display device of claim 14, wherein a ratio of the thickness of the second portion of the second upper titanium layer to a total thickness of the second conductive layer is in a range of about 13% to about 20%, and
a ratio of the thickness of the first portion of the second upper titanium layer to the total thickness of the second conductive layer is about 0.5% or greater.

26. An electronic apparatus comprising:
a processor which provides input image data;
a display device which displays an image based on the input image data; and
a power supply which supplies power to the display device,
wherein the display device includes:
a substrate;
a first conductive layer disposed on the substrate and including a first uppermost layer and a first lower layer below the first uppermost layer;
a first insulating layer disposed on the substrate to cover the first conductive layer;
a gate insulating layer disposed on the first insulating layer;
a second conductive layer disposed on the gate insulating layer and including a second uppermost layer and a second lower layer below the second uppermost layer;
a second insulating layer disposed on the first insulating layer to cover the second conductive layer; and
a third conductive layer disposed on the second insulating layer and connected to each of the first conductive layer and the second conductive layer through a first contact hole and a second contact hole,
wherein the first contact hole is defined through the first insulating layer and the second insulating layer to expose a first portion of the first uppermost layer,
the second contact hole is defined through the second insulating layer to expose a first portion of the second uppermost layer,
the third conductive layer is disposed in the first contact hole and the second contact hole and is in contact with the first portion of the first uppermost layer and the first portion of the second uppermost layer,
an upper surface of a second portion of the first uppermost layer is not in contact with the third conductive layer,
an upper surface of a second portion of the second uppermost layer is not in contact with the third conductive layer,
a thickness of the second portion of the second uppermost layer is greater than a thickness of the first portion of the second uppermost layer, and
a thickness of the second portion of the first uppermost layer is greater than or equal to a thickness of the first portion of the first uppermost layer.

27. An electronic apparatus comprising:
a processor which provides input image data;
a display device which displays an image based on the input image data; and
a power supply which supplies power to the display device,
wherein the display device includes:
a substrate;
a first conductive layer disposed on the substrate and including a first upper titanium layer and a first lower aluminium layer;
a first insulating layer disposed on the substrate to cover the first conductive layer;
a gate insulating layer disposed on the first insulating layer;
a second conductive layer disposed on the gate insulating layer and including a second upper titanium layer and a second lower aluminium layer;
a second insulating layer disposed on the first insulating layer to cover the second conductive layer; and
a third conductive layer disposed on the second insulating layer and connected to each of the first conductive layer and the second conductive layer through a first contact hole and a second contact hole,
wherein the first contact hole is defined through the first insulating layer and the second insulating layer to expose a first portion of the first upper titanium layer,
the second contact hole is defined through the second insulating layer to expose a first portion of the second upper titanium layer,
the third conductive layer is disposed in the first contact hole and the second contact hole and is in contact with the first portion of the first upper titanium layer and the first portion of the second upper titanium layer,
an upper surface of a second portion of the first upper titanium layer is not in contact with the third conductive layer,
an upper surface of a second portion of the second upper titanium layer is not in contact with the third conductive layer,
a thickness of the second portion of the second upper titanium layer is greater than a thickness of the first portion of the second upper titanium layer, and
a thickness of the second portion of the first upper titanium layer is greater than or equal to a thickness of the first portion of the first upper titanium layer.
